# EUROPÄISCHE PATENTSCHRIFT

(11) **EP 2 039 990 B1**
(45) Veröffentlichungstag und Bekanntmachung des Hinweises auf die Patenterteilung: **27.10.2010**
(21) Anmeldenummer: 08016579.8
(22) Anmeldetag: 19.09.2008
(51) Int. Cl.: F21V 19/00, F21K 99/00

(54) **Trägerelement mit Leuchtdiodeneinheiten**
Support element with light emitting diode units
Elément de support doté d'unités de diodes luminescentes

(30) Priorität: 20.09.2007 DE 102007044892
(43) Veröffentlichungstag der Anmeldung: 25.03.2009
(73) Patentinhaber: Siteco Beleuchtungstechnik GmbH, 83301 Traunreut (DE)
(72) Erfinder: Härtl, Michael, 83278 Traunstein (DE); Lukanow, Stephan, 83377 Vachendorf (DE); Teklak, Janusz, 83278 Traunstein (DE); Meyer, Clemens, 83278 Traunstein (DE)
(74) Vertreter: Schohe, Stefan

(56) Entgegenhaltungen:
- EP-A- 1 460 332
- US-A- 6 135 780
- US-A1- 2007 064 425

## Beschreibung

Die Erfindung betrifft bestückte und nicht bestückte Trägerelemente für Leuchtdiodeneinheiten, ein Verfahren zur Bestückung solcher Trägerelemente und eine Leuchte, welche ein oder mehrere solcher Trägerelemente enthält.

Leuchtdioden oder Licht emittierende Dioden (LEDs) werden zunehmend für Beleuchtungsaufgaben herangezogen. Da Leuchtdioden in der Regel eine rotationssymmetrische Lichtabstrahlcharakteristik besitzen, ist zur Erzeugung von nicht rotationssymmetrischen Abstrahlcharakteristiken, wie sie vielfach in der Lichttechnik, insbesondere im Außenleuchtenbereich gewünscht oder erforderlich sind, eine Optik erforderlich, welche die Asymmetrie erzeugt. Es gibt mittlerweile auch Lichtquellen auf LED-Basis, die eine nicht rotationssymmetrische Lichtabstrahlung aufweisen, beispielsweise die OSRAM Golden Dragon Argus Oval. Um einen ausreichenden Lichtstrom zu erzeugen, ist es allerdings erforderlich, mehrere derartige Leuchtdiodeneinheiten zusammenzufassen, beispielsweise auf einer Leiterplatte, auf der die Leuchtdiodeneinheiten aufgelötet werden.

Um eine bestimmte gewünschte Lichtabstrahlcharakteristik der gesamten Leuchte zu erreichen ist es bislang nötig, entweder für die Gesamtheit der Leuchtdioden eine geeignete Optik vorzusehen, welche die gewünschte Lichtstärkeverteilung erzeugt, oder aber eine Leiterplatte mit asymmetrisch Licht abstrahlenden Leuchtdiodeneinheiten mit einer jeweils auf die gewünschte Lichtabstrahlcharakteristik abgestellten Orientierung der Leuchtdiodeneinheit zu bestücken. Wenn die Lichtabstrahlcharakteristik in einer festen räumlichen Beziehung zu dem Muster der Kontaktelemente der Leuchtdiodeneinheit ("Footprint") steht, muß, wenn die Orientierung der asymmetrischen Lichtabstrahlcharakteristik geändert wird, auch die dem Footprint entsprechende Anordnung der Kontaktstellen auf der Leiterplatte geändert werden. Dies bedeutet, daß man für jede neue gewünschte Lichtabstrahlcharakteristik ein neues Design für eine Leiterplatte entwerfen und realisieren muß. Dies erhöht die Herstellungskosten und macht häufig die Verwendung von LEDs bei kleineren Serien unrentabel bzw. ungeeignet für Anwendungen, bei denen eine individuelle Abstimmung auf lokale Gegebenheiten erforderlich ist.

EP 1 460 332 A2 offenbart eine Anzeigeleuchte, welche mehrere zylindrische Gehäuse aufweist, die in Längsrichtung aufeinandergesteckt werden können und eine elektrische Verbindung miteinander eingehen. Als Leuchtmittel sind LEDs offenbart.

US 6 135 780 A offenbart eine Trägerplatine mit Aufnahmeeinrichtungen für zwei Lampenfassungen. Die Lampenfassungen können zwei verschiedene Arten von Lampen aufnehmen. Die elektrischen Zuleitungen für die Lampenfassungen sind auf der Trägerplatine aufgedruckt und umfassen mehrere Anschlusskontakte, die um Ausschnitte für die Lampenfassungen angeordnet sind.

US 2007/0064425 A1 offenbart eine Beleuchtungsvorrichtung mit mehreren auf schmalen Platinen angebrachten LEDs, wobei die Platinen auf einem gemeinsamen Träger in Längsrichtung drehbar gelagert sind.

Es ist die Aufgabe der Erfindung, einen Aufbau für Leuchten mit Leuchtdioden als Lichtquelle und mit einer asymmetrischen Lichtabstrahlung zur Verfügung zu stellen, der kostengünstiger und/oder variabler bzw. flexibler als nach dem Stand der Technik realisiert werden kann.

Erfindungsgemäß wird diese Aufgabe dadurch gelöst, daß ein spezielles Trägerelement mit einem festgelegten Verlauf von Leiterelementen zur Verfügung gestellt wird, das mit Leuchtdiodeneinheiten und ggf. den Leuchtdiodeneinheiten zugeordneten optischen Elementen mit jeweils variabler Orientierung bestückt werden kann, so daß trotz des festgelegten Verlaufs der Leiterelemente mit demselben Trägerelement unterschiedliche Lichtverteilungen erreicht werden können.

Ein solches Trägerelement weist eine oder mehrere Kontaktstellen zur elektrischen Verbindung mit einem oder mehreren Kontaktelementen der Leuchtdiodeneinheit, die für den elektrischen Anschluß der Leuchtdiodeneinheit vorgesehen sind, auf und weist ferner Leitungselemente, beispielsweise Leiterbahnen, auf, über welche diese Kontaktstellen an eine elektrische Versorgung angeschlossen werden können. In der Regel weisen die mit den Kontaktstellen verbundenen Leiterelemente eine oder mehr Anschlußstellen zum Verbinden mit einer elektrischen Stromversorgung auf. Die Leiterelemente können weiterhin elektrische Verbindungen zwischen Bauelementen herstellen, die an dem Trägerelement montiert sind, beispielsweise eine Reihen- oder Parallelschaltung mehrerer Leuchtdiodeneinheiten oder anderer elektrischer Komponenten. Vorzugsweise legen sie einen Schaltkreis oder einen Teil eines Schaltkreises fest, der über geeignete Anschlußstellen mit einer Stromversorgung verbunden werden kann.

Das erfindungsgemäße Trägerelement kann insbesondere eine Leiterplatte sein. Es kann aber auch ein anderes Bauelement sein, an dem Leuchtdiodeneinheiten mechanisch befestigt werden können und welches vorgegebene Leitungswege mit Kontaktstellen aufweist, die mit Kontaktelementen einer Leuchtdiodeneinheit elektrisch leitend verbunden werden können.

Die Leuchtdiodeneinheit kann eine einzelne Leuchtdiode sein oder eine einzelne Leuchtdiode umfassen, aber auch durch eine Gruppe von Leuchtdioden gebildet werden oder eine Gruppe von Leuchtdioden umfassen. Gemäß einer Ausführungsform der Erfindung ist vorgesehen, daß die Leuchtdiodeneinheit eine oder mehrere Leuchtdioden und eine diesen Leuchtdioden zugeordnete Optik im Sinne einer Anordnung von einem oder mehreren optischen Elementen, wie Linsen, Prismen, Reflektoren und dergleichen, aufweist, die in der Leuchtdiodeneinheit in einer festen räumlichen Beziehung zu der oder den Leuchtdioden steht. Generell kann eine Leuchtdiodeneinheit auch ein anderes Licht abgebendes Bauteil sein, welches eine oder mehrere Leuchtdioden als Lichtquellen aufweist und elektrisch ein oder mehrere elektrische Kontaktelemente aufweist, die mit einem Trägerelement, insbesondere einer Leiterplatte verbunden werden können.

Gemäß einem ersten Aspekt stellt die Erfindung ein Trägerelement zur Befestigung und elektrischen Verbindung einer oder mehrerer Leuchtdiodeneinheiten, insbesondere eine Leiterplatte, mit einer oder mehreren Montagestellen für jeweils eine Leuchtdiodeneinheit, wobei jede Montagestelle eine oder mehrere Kontaktstellen zur elektrischen Verbindung mit der Leuchtdiodeneinheit aufweist, die in elektrischer Verbindung mit Leiterelementen des Trägerelements stehen, wobei eine Leuchtdiodeneinheit an einer Montagestelle derart verdrehsicher befestigbar ist, daß ein elektrischer Kontakt zwischen einem oder mehreren Kontaktelementen der Leuchtdiodeneinheit mit einer oder mehreren Kontaktstellen des Trägerelements hergestellt wird, zur Verfügung, welches dadurch gekennzeichnet ist, daß die Leuchtdiodeneinheit an einer Montagestelle in mehreren gegeneinander verdrehten Stellungen derart befestigbar ist, daß ein oder mehrere ihrer Kontaktelemente jeweils mit entsprechenden Kontaktstellen der Montagestelle in elektrischer Verbindung stehen.

Gemäß einer bevorzugten Ausführungsform ist vorgesehen, daß an der Montagestelle der Trägerplatte für eine Leuchtdiodeneinheit Kontaktstellen für alle elektrischen Anschlüsse der Leuchtdiodeneinheit vorhanden sind und dementsprechend auch in jeder der gegeneinander verdrehten Stellungen alle elektrischen Anschlüsse der Leuchtdiodeneinheit bei montierter Leuchtdiodeneinheit elektrisch mit Kontaktstellen der Montagestelle verbunden sind, so daß die Leuchtdiodeneinheit über die Kontaktstellen und die damit verbundenen Leiterelemente betrieben werden kann. Es kann allerdings auch vorgesehen sein, daß das Trägerelement so ausgebildet ist bzw. eine Leuchtdiodeneinheit so auf einem Trägerelement montiert ist, daß in einem montierten Zustand der Leuchtdiodeneinheit nur ein Teil der Kontaktelemente der Leuchtdiodeneinheit, welche elektrische Anschlüsse der Leuchtdiodeneinheit bilden, in elektrischer Verbindung mit Kontaktstellen der Montagestelle stehen, wobei der Anschluß der restlichen Kontaktelemente bzw. elektrischen Anschlüsse der Leuchtdiodeneinheit auf anderem Wege vorgesehen ist, beispielsweise durch einen separaten Draht, eine Verbindung mit einem Sammelleiter, wie einer Stromschiene, oder auch eine elektrische Verbindung mit einem weiteren Trägerelement. Erfindungsgemäß kann vorgesehen sein, daß in jeder der besagten Stellungen diejenigen Kontaktelemente der Leuchtdiodeneinheit, die über das Trägerelement elektrisch angeschlossen werden oder anzuschließen sind, in elektrischer Verbindung mit Kontaktstellen der Montagestelle stehen, wenn die Leuchtdiodeneinheit an dem Trägerelement montiert ist.

Erfindungsgemäß kann die Befestigung der Leuchtdiodeneinheit an dem Trägerelement durch die gleichen Mittel erfolgen, welche auch den elektrischen Kontakt mit den Kontaktstellen des Trägerelements herstellen.

Gemäß einer bevorzugten Ausführungsform kann vorgesehen sein, daß die Leuchtdiodeneinheit dadurch an dem Trägerelement befestigt wird, daß die Kontaktelemente der Leuchtdiodeneinheit an den Kontaktstellen des Trägerelements angelötet werden. In anderen Ausführungsformen kann vorgesehen sein, daß Kontaktelemente der Leuchtdiodeneinheit durch Löcher in dem Trägerelement hindurchgesteckt werden, beispielsweise bei Verwendung einer Leiterplatte mit Durchkontaktierung, oder in Vertiefungen des Trägerelements eingesteckt werden. Die Erfindung kann insbesondere auch vorsehen, daß eine Verbindung des Trägerelements mit der Leuchtdiodeneinheit über ein Paar von komplementären Steckerelementen erfolgt, welche die beiden Teile mechanisch und elektrisch miteinander verbinden. Dies können beispielsweise formschlüssig ineinandergreifende Steckerelemente sein, beispielsweise ein Steckerelement mit einem Vorsprung und ein Steckerelement mit einer komplementären Vertiefung, wie sie bei elektrischen Verbindungen üblich sind. Grundsätzlich können auch mehrere Paare von solchen komplementären Steckerelementen für die Verbindung zwischen Leuchtdiodeneinheit und Trägerelement vorgesehen sein. Beispielsweise kann vorgesehen sein, daß die Leuchtdiodeneinheit ein oder mehrere Stecker aufweist, die in komplementäre Steckerelemente des Trägerelements eingesteckt werden können.

Die Erfindung kann allerdings auch vorsehen, daß die mechanische Verbindung zwischen Leuchtdiodeneinheit und die elektrische Kontaktierung ganz oder teilweise durch unterschiedliche Mittel erfolgt. Beispielsweise kann die Leuchtdiodeneinheit Positionierstifte oder Rastelemente aufweisen, die in entsprechende Löcher bzw. Rastaufnahmen des Trägerelements eingreifen und keine elektrische Verbindung mit anderen Anschlußstellen des Trägerelements herstellen, sondern ausschließlich eine mechanische Befestigungsfunktion haben. Bei derartigen Ausführungsformen können umgekehrt die Kontaktstellen und die zugehörigen Kontaktelemente der Leuchtdiodeneinheit keine mechanische Befestigungsfunktion haben und beispielsweise die Form von Kontaktpads oder Federzungen haben, die bei einer mechanischen Verbindung gegen entsprechende Kontaktstellen des anderen Teils gepreßt werden. Es kann allerdings auch vorgesehen sein, daß bei einer Ausführungsform, bei welcher das Trägerelement Befestigungsmittel aufweist, die lediglich eine mechanische Verbindung herstellen, weitere Verbindungselemente vorhanden sind, die sowohl eine mechanische als auch eine elektrische Verbindung beim Anbringen der Leuchtdiodeneinheit an dem Trägerelement herstellen.

Die Erfindung kann vorsehen, daß die Montagestelle mehrere Gruppen von Kontaktstellen aufweist, wobei die geometrische Anordnung der Kontaktstellen innerhalb einer Gruppe jeweils der geometrischen Anordnung der mit ihnen zu verbindenden Kontaktelemente der Leuchtdiodeneinheit entspricht, wobei sich die Position der Kontaktstellen einer Gruppe durch eine Rotation aus der Position der Kontaktstellen einer anderen Gruppe ergibt.

Bei dieser Ausführungsform entspricht die Position der Kontaktstellen in jeder Gruppe der Position der mit dem Trägerelement zu verbindenden Kontaktelemente der Leuchtdiodeneinheit in einer bestimmten Drehstellung der Leuchtdiodeneinheit. Wenn beispielsweise die Position einer ersten Gruppe von Kontaktstellen der Position der Kontaktelemente der Leuchtdiodeneinheiten in der ersten Position entspricht, entspricht die Position einer zweiten Gruppe von Kontaktstellen der Position der Kontaktelemente der Leuchtdiodeneinheit, wenn man diese von dieser ersten Stellung in eine zweite Stellung dreht.

Grundsätzlich müssen die besagten Gruppen von Kontaktstellen nicht disjunkt sein, d.h. eine Kontaktstelle kann zu mehreren derartigen Gruppen gehören. Wichtig ist, daß in verschiedenen Drehstellungen eine Kontaktierung der Leuchtdiodeneinheit möglich ist, so daß die Leuchtdiodeneinheit betrieben werden kann. Umgekehrt muß nicht jede Kontaktstelle der Montagestelle ein Element einer der besagten Gruppen sein. Beispielsweise können weitere Kontaktstellen vorhanden sein, die nur in einer der vorgesehenen Drehstellungen oder nur in bestimmten vorgesehenen Drehstellungen der Leuchtdiodeneinheit angeschlossen werden.

Die besagte Rotation kann insbesondere eine Rotation um eine Achse senkrecht zu der Oberfläche sein, an der die Leuchtdiodeneinheit befestigt wird. Bei einem ebenen Trägerelement, beispielsweise einer Leiterplatte, wäre dies eine Achse senkrecht zu dem Trägerelement bzw. zu der Leiterplatte.

Die Erfindung kann vorsehen, daß mehrere einander entsprechende Kontaktstellen in verschiedenen Gruppen auf einem Kreisbogen liegen und elektrisch leitend miteinander verbunden sind. Vorzugsweise sind die einander entsprechenden Kontaktstellen in allen Gruppen elektrisch leitend miteinander verbunden und/oder liegen auf einem Kreisbogen. Gegebenenfalls kann dies jedoch auch nur für die einander entsprechenden Kontaktstellen eines Teils der Gruppen gelten. In der Regel werden einander entsprechende Kontaktstellen in den verschiedenen Drehstellungen der Leuchtdiodeneinheit mit demselben Kontaktelement der Leuchtdiodeneinheit verbunden.

Es kann vorgesehen sein, daß an der Montagestelle mehrere Gruppen von Kontaktstellen vorgesehen sind, wobei die Kontaktstellen innerhalb einer Gruppe elektrisch leitend miteinander verbunden sind, wobei die Abfolge der Winkelabstände der Kontaktstellen, bezogen auf eine Rotation um eine Achse senkrecht zu der Oberfläche, an welcher die Leuchtdiodeneinheit anbringbar ist, in jeder Gruppe gleich ist.

Das Trägerelement kann eine oder mehrere Gruppen von diskreten Kontaktstellen aufweisen, wobei die Kontaktstellen in einer Gruppe jeweils auf einem Kreisbogen liegen und wobei ein Kontaktelement der Leuchtdiodeneinheit wahlweise mit einer der Kontaktstellen einer Gruppe kontaktiert werden kann.

Die Kontaktstellen einer Gruppe können dabei mit einem gemeinsamen Anschluß auf dem Trägerelement verbunden sein.

Gemäß einer besonderen Ausführungsform ist dabei vorgesehen, daß jede der Kontaktstellen der Gruppe über leitende Verbindungsabschnitte, insbesondere radial bezüglich des Kreisbogens verlaufende Verbindungsabschnitte, mit einem gemeinsamen Leiterelement, wie einer Leiterbahn auf einer Leiterplatte, verbunden ist, welches insbesondere kreisbogenförmig und bevorzugt konzentrisch zu dem Kreisbogen verläuft, auf dem die Gruppe von Kontaktstellen liegt. Dieses Leiterelement, das bezüglich der Gruppe von Kontaktstellen die Funktion eines Busses übernimmt, kann dann die gemeinsame Anschlußstelle der Kontaktstellen aufweisen oder mit einer solchen gemeinsamen Anschlußstelle verbunden sein.

Ein Kreisbogen kann in diesem Zusammenhang eine vollständige Kreislinie oder ein Teil einer Kreislinie sein. Gemäß bevorzugten Ausführungsformen kann der Kreisbogen ein Teil einer Kreislinie sein, bei dem die Radien am Anfangspunkt und Endpunkt dieses Kreisbogens einen Winkel von 90° oder weniger, bei besonderen Ausführungsformen z.B. einen Winkel von 15°, 30° oder 60° miteinander einschließen.

Die Kontaktstellen an einer Montagestelle können, müssen aber nicht alle auf einem Kreis liegen. Wenn beispielsweise der Abstand der Kontaktelemente der Leuchtdiodeneinheit von dem Zentrum der Rotation unterschiedlich ist, können die Kontaktstellen auf mehreren konzentrischen Kreisbögen mit unterschiedlichen Radien liegen.

Gemäß einem zweiten Aspekt der Erfindung wird ein Trägerelement, insbesondere wie vorangehend umschrieben, zur Befestigung und elektrischen Verbindung einer oder mehrerer Leuchtdiodeneinheiten, insbesondere eine Leiterplatte, mit einer oder mehreren Montagestellen für jeweils eine Leuchtdiodeneinheit, wobei jede Montagestelle jeweils eine oder mehrere Kontaktstellen aufweist, die in elektrischer Verbindung mit Leiterelementen des Trägerelements stehen, wobei eine Leuchtdiodeneinheit an einer Befestigungsstelle derart verdrehsicher befestigbar ist, daß ein oder mehrere Kontaktelemente der Leuchtdiodeneinheit jeweils mit einer Kontaktstelle des Trägerelements in elektrischer Verbindung stehen, zur Verfügung gestellt, welches dadurch gekennzeichnet ist, daß eine Montagestelle eine Einrichtung zum Befestigen eines optischen Elements zum optischen Zusammenwirken mit einem an der Montagestelle angebrachten Leuchtdiodeneinheit aufweist, wobei die Einrichtung zum Befestigen des optischen Elements das Fixieren des optischen Elements in mehreren Positionen gestattet, von denen jede sich durch Drehen des optischen Elements um eine Achse aus einer anderen dieser Positionen ergibt.

Die besagte Achse kann eine Achse durch das optische Element und/oder eine Achse senkrecht zu der Oberfläche, an der das optische Element angebracht wird, sein. Es kann insbesondere vorgesehen sein, daß sowohl die Leuchtdiodeneinheit als auch das optische Element in mehreren Positionen, die bezüglich einer Rotation um eine Drehachse zueinander versetzt sind, an dem Trägerelement angebracht werden können, wobei sich die möglichen Positionen des optischen Elements einerseits und der Leuchtdiodeneinheit andererseits durch Rotation um dieselbe Achse, aber auch durch Rotation um unterschiedliche Achsen ergeben können.

Das Trägerelement kann mehrere auf einem Kreisbogen liegende Befestigungselemente aufweisen, mit denen eine bestimmte Befestigungsstelle des optischen Elements verbunden werden kann.

Besitzt das optische Element mehrere Befestigungsstellen, an denen es mit dem Trägerelement verbunden werden soll, kann vorgesehen sein, daß mehrere Gruppen von auf einem Kreisbogen liegenden Befestigungselementen an der Montagestelle vorgesehen sind.

Die Befestigungseinrichtung legt eine bestimmte räumliche Beziehung zwischen dem optischen Element und der zugeordneten Leuchtdiodeneinheit fest, z.B. dahingehend, daß das optische Element um eine gegenüber der Leuchtdiodeneinheit feststehende Achse drehbar ist oder eine bestimmte Position und/oder Orientierung gegenüber der Leuchtdiodeneinheit hat.

Die Befestigungseinrichtung für das optische Element kann, muß aber nicht die Position des optischen Elements vollständig festlegen. Es kann insbesondere vorgesehen sein, daß die Befestigungseinrichtung die Freiheitsgrade der Bewegung des optischen Elements beschränkt, beispielsweise auf eine Drehbewegung um eine Achse senkrecht zu der Oberfläche des Trägerelements, wobei die Fixierung in einer unveränderlichen Position, also die Festlegung der verbleibenden Freiheitsgrade, für den Gebrauchszustand auf andere Weise, beispielsweise durch Kleben erfolgt.

Die Befestigungseinrichtung kann als Befestigungselement oder Befestigungselemente beispielsweise Löcher, Stifte, Erhebungen, Vertiefungen oder präparierte Klebe- oder Lötstellen aufweisen.

Das erfindungsgemäße Trägerelement kann ein kreisbogenförmiges Befestigungselement zum Festlegen der Position des optischen Elements aufweisen, an oder auf bzw. in dem eine Befestigungsstelle des optischen Elements in mehreren Positionen angebracht werden kann.

Die Erfindung kann vorsehen, daß mehrere derartige kreisbogenförmige Befestigungselemente vorhanden sind, die vorzugsweise zueinander konzentrisch sind. Es kann vorgesehen sein, daß das kreisbogenförmige Befestigungselement als kreisbogenförmiger Schlitz zum Einstecken eines Stifts des optischen Elements oder eines anderen geeigneten vorspringenden Abschnitts des optischen Elements ausgebildet ist, wobei gemäß bestimmten Ausführungsformen das optische Element nach dem Einstecken des vorspringenden Abschnitts, z.B. des Stifts, in dem kreisbogenförmigen Schlitz noch verdrehbar ist. Die Fixierung des optischen Elements erfolgt dann auf geeignete Weise, z.B. durch Kleben. Statt einem Schlitz kann auch eine Vertiefung vorgesehen sein, in die ein Stift oder ein kreisbogenförmiger Wandabschnitt des optischen Elements eingesteckt wird. Es kann auch vorgesehen sein, daß das Trägerelement als kreisbogenförmiges Befestigungselement einen kreisbogenförmigen Leiterstreifen aufweist, an dem eine entsprechende Befestigungsstelle des optischen Elements angelötet werden kann.

Die Erfindung kann vorsehen, daß an einer oder mehreren Montagestellen eine Leuchtdiodeneinheit angebracht ist.

Dabei kann vorgesehen sein, daß die Kontaktstelle bzw. Kontaktstellen der Montagestelle sich auf derjenigen Seite des Trägerelements befinden, an welcher die Leuchtdiodeneinheit montiert ist, wobei ein oder mehrere Kontaktelemente der Leuchtdiodeneinheit jeweils auf eine Kontaktstelle des Trägerelements aufgesetzt sind.

Die Erfindung kann vorsehen, daß die Kontaktelemente der Leuchtdiodeneinheit durch ein Reflow-Lötverfahren an den Kontaktstellen des Trägerelements befestigt sind.

Es kann vorgesehen sein, daß an einer Montagestelle ein einer Leuchtdiodeneinheit zugeordnetes optisches Element angebracht ist.

Die Erfindung kann vorsehen, daß das optische Element durch eine Rast- oder Steckverbindung mit dem Trägerelement verbunden ist.

Die Erfindung kann vorsehen, daß das optische Element durch Kleben oder Löten an dem Trägerelement fixiert ist.

Die Erfindung stellt auch eine Leuchte, insbesondere eine Außenleuchte, welche eine oder mehrere Lichtquellen in Form von Leuchtdioden aufweist, zur Verfügung, welche ein oder mehrere Trägerelemente, wie vorangehend beschrieben, aufweist.

Die erfindungsgemäße Leuchte kann insbesondere eine Außenleuchte, wie z.B. eine Straßenleuchte sein.

Gemäß einer Ausführungsform der Erfindung weist eine solche Leuchte eine Leiterplatte auf, in der mehrere Leuchtdiodeneinheiten vorgesehen sind, deren Hauptmaximum der Lichtabstrahlung symmetrisch zu einer Mittenebene in der Leuchte ausgerichtet ist. Bei dieser Ausführungsform erzeugen die Leuchtdiodeneinheiten eine bezüglich der Mittenebene der Leuchte symmetrische Lichtverteilung auf der beleuchteten Fläche, wie z.B. einer Fahrbahn, auf beiden Seiten der Leuchte.

Gemäß einer bevorzugten Ausführungsform sind mehrere Gruppen von Leuchtdiodeneinheiten vorgesehen, deren Hauptabstrahlrichtungen jeweils parallel zueinander sind, wobei jedoch die Hauptabstrahlrichtungen der Leuchtdiodeneinheiten einen unterschiedlichen Winkel mit der Mittenebene der Leuchte einschließen. Während in einer Ausführungsform die Hauptabstrahlrichtung einer ersten Gruppe von Leuchtdiodeneinheiten beispielsweise in einer Projektion auf die Ebene des Trägerelements senkrecht zu der Mittenebene ist, können weitere Gruppen von Leuchtdiodeneinheiten jeweils eine Hauptabstrahlrichtung aufweisen, die in dieser Projektion mit einer Geraden senkrecht zu der Mittenebene einen nicht verschwindenden Winkel einschließt, der beispielsweise zwischen 5° und 30° bzw. zwischen -5° und -30°, bedingt durch die symmetrische Ausbildung, liegen kann. Hierdurch kann eine Lichtbandknickung erzeugt werden, die insbesondere für Straßenleuchten von Vorteil ist, die nicht mittig über der Fahrbahn, sondern am Fahrbahnrand angeordnet sind.

Grundsätzlich können die einzelnen Leuchtdiodeneinheiten jeweils individuell ausgerichtet sein. Gemäß einer bevorzugten Ausführungsform werden jedoch mehrere Leuchtdiodeneinheiten, die entweder eine asymmetrische Lichtabstrahlcharakteristik haben oder, in der vorangehend beschriebenen Weise, mit einer Optik gekoppelt sind, die eine asymmetrische Lichtabstrahlcharakteristik erzeugt, in einer oder mehreren Gruppen zusammengefaßt, wobei die Leuchtdiodeneinheiten in einer Gruppe jeweils eine parallele Hauptabstrahlrichtung aufweisen. Die Leuchtdiodeneinheiten in einer Gruppe können, müssen aber nicht, in einem Flächenbereich der Leiterplatte angeordnet sein, in den sich keine Leuchtdiodeneinheiten anderer Gruppen befinden. Erfindungsgemäß kann auch vorgesehen sein, daß Gruppen von Leuchtdiodeneinheiten, die zueinander parallele Hauptabstrahlrichtungen aufweisen, einander überlagern, so daß zwischen Leuchtdiodeneinheiten mit einer bestimmten Hauptabstrahlrichtung eine oder mehrere Leuchtdiodeneinheiten mit einer anderen Hauptabstrahlrichtung angeordnet sind.

Die Erfindung stellt auch ein Verfahren zum Bestücken einer erfindungsgemäßen Leiterplatte mit einer oder mehreren Leuchtdiodeneinheiten zur Verfügung, wobei die Kontaktstellen der Leiterplatte auf der Seite der Leiterplatte vorgesehen sind, auf der die Leuchtdiodeneinheit angebracht wird, welches dadurch gekennzeichnet ist, daß ein haftvermittelndes Lötmittel auf die Kontaktstellen der Montagestelle aufgebracht wird, die Leuchtdiodeneinheit auf die Leiterplatte in der gewünschten Orientierung so aufgesetzt wird, daß die zu verbindenden Kontaktelemente der Leuchtdiodeneinheit über den zugehörigen Kontaktstellen der Montagestelle der Leiterplatte liegen, und daß anschließend ein Lötvorgang durchgeführt wird, durch welchen die Kontaktstellen mit den Kontaktelementen der Leuchtdiodeneinheit verbunden werden. Gemäß einer Ausführungsform der Erfindung werden alle Kontaktstellen der Montagestellen mit einem haftvermittelnden Lötmittel versehen.

Da das Lötmittel auch im nicht gelöteten Zustand haftvermittelnd ist, wird die Leuchtdiodeneinheit bis zu dem Lötvorgang durch das Lötmittel in ihrer Position gehalten.

Gemäß einer bevorzugten Ausführungsform wird die Leuchtdiodeneinheit während des Lötvorgangs durch eine Halteeinrichtung fixiert.

Um zu verhindern, daß sich die Position der Leuchtdiodeneinheit während des Lötvorgangs ändert, ist es vorteilhaft, wenn für die verschiedenen möglichen Positionen der Leuchtdiodeneinheit jeweils diskrete Kontaktstellen vorgesehen sind, die in Umfangsrichtung, bezogen auf eine Rotation um eine Achse, welche der Symmetrie der Anordnung der Kontaktstellen entspricht, eine relativ kleine Ausdehnung besitzen. Haben die Kontaktstellen eine größere Ausdehnung in Drehrichtung oder sind sie kreisbogenförmig, kann es unter Umständen bei dem Lötvorgang zu einem Verschwimmen der Leuchtdiodeneinheit kommen. Dem kann ggf. dadurch begegnet werden, daß während des Lötens die Leuchtdiodeneinheit in geeigneter Weise in ihrer Position gehalten wird.

Die Erfindung kann vorsehen, daß die Leuchtdiodeneinheit während des Lötvorgangs durch eine Halteeinrichtung fixiert wird.

Auf diese Weise kann auch dann, wenn die Kontaktstelle in einer Kreisbogenform ausgebildet ist, eine zuverlässige Positionierung der Leuchtdiodeneinheit erreicht werden.

Gemäß einer vorteilhaften Ausführungsform kann vorgesehen sein, daß das optische Element vor oder nach dem Lötvorgang, mit dem die Leuchtdiodeneinheit befestigt wird, angebracht werden. Gemäß einer Ausführungsform ist es jedoch auch möglich, das optische Element ebenfalls durch einen Lötvorgang zu fixieren, vorteilhafterweise durch den gleichen Lötvorgang, mit dem auch die Leuchtdiodeneinheit fixiert wird.

Die Erfindung kann vorsehen, daß das Trägerelement an der Montagestelle eine Befestigungseinrichtung mit einer oder mehreren Befestigungsstellen für ein optisches Element aufweist, die eine Befestigung des optischen Elements in verschiedenen Orientierungen gestatten, daß vor dem Lötvorgang die Befestigungsstellen für das optische Element mit einem haftvermittelnden Lötmittel versehen werden, das optische Element in der gewünschten Orientierung auf oder in die entsprechende Befestigungsstelle oder Befestigungsstellen aufgesetzt wird und in einem Lötvorgang das optische Element und die zugehörige Leuchtdiodeneinheit jeweils mit dem Trägerelement verbunden werden.

Mit dem erfindungsgemäßen Trägerelement, insbesondere wenn es als Leiterplatte ausgebildet ist, wird eine Positionierung der Leuchtdiodeneinheiten in verschiedenen Drehwinkeln ermöglicht. Gemäß bevorzugten Ausführungsformen ist eine Leiterplatte so ausgebildet, daß ein Drehwinkel von bis zu 90° möglich ist. Durch Rotation eines Kontaktmusters (Footprint) einer gängigen LED um die gewünschte Drehachse und mit den gewünschten Drehwinkeln kann ein Muster von Kontaktstellen generiert werden, das die Montage der Leuchte mit den gewünschten Orientierungen ermöglicht. Damit sind universelle Trägerelemente, insbesondere universelle Leiterplatten herstellbar, die bei gleichbleibendem Design der leitenden Verbindungen und der Anschlußstellen die Bestückung mit Leuchtdioden bzw. Leuchtdiodeneinheiten in unterschiedlichen Orientierungen, je nach der gewünschten Lichtabstrahlcharakteristik bestückt werden können, beispielsweise durch einen Pick-and-Place-Roboter.

Gemäß dem zweiten Aspekt der Erfindung, der alternativ oder komplementär zu dem ersten Aspekt ist, wird die variable asymmetrische Ausstrahlung einer Leuchtdiodeneinheit, insbesondere einer Leuchtdiode, durch die Möglichkeit der unterschiedlichen Positionierung einer der Leuchtdiodeneinheit, insbesondere einer Leuchtdiode, zugeordneten Optik realisiert. In einer Ausführungsform wird die Optik über Stifte und entsprechende Löcher in der Leiterplatte geführt. Die Leuchtdiode ist dabei in einer Standardposition (Normalposition) aufgelötet und die Optik dergestalt eingerichtet, daß eine Montage der Optik in mehreren zueinander (und damit auch zu der Leuchtdiode) gedrehten Positionen möglich ist. Vorteilhafterweise werden Führungszapfen, die mit Löchern in dem Trägerelement zusammenwirken, am Rand der Optik vorgesehen, um definierte Löcher und eine feinere Winkelauflösung zu erhalten.

Gemäß einer Ausführungsform kann das Trägerelement, insbesondere eine Leiterplatte, einen Schlitz in Umfangsrichtung aufweisen, in dem die Optik stufenlos verstellt werden kann. Die Positionierung in der geeigneten bzw. gewünschten Orientierung kann, sofern sie nicht durch einen Roboter geschieht, mittels einer Schablone erfolgen, wobei danach die Optik durch ein geeignetes Verbindungsmittel, z.B. durch Kleben in ihrer Position fixiert wird.

Eine asymmetrische Lichtabstrahlcharakteristik kann eine Lichtabstrahlcharakteristik sein, die nicht rotationssymmetrisch ist, insbesondere nicht rotationssymmetrisch bezüglich einer mittleren Lichtabstrahlrichtung und/oder einer Senkrechten zu einer Lichtaustrittsfläche der Leuchte, Leuchtdiodeneinheit oder Leuchtdiode. Eine asymmetrische Lichtabstrahlcharakteristik kann insbesondere jedoch auch eine Lichtabstrahlcharakteristik sein, bei der die Lichtstärkeverteilungskurve in einer Ebene, welche den oder einen Licht abstrahlenden Bereich der Leuchte, der Leuchtdiodeneinheit bzw. der Leuchtdiode schneidet, keine Symmetrie bezüglich einer Geraden in dieser Ebene aufweist, welche die Licht abstrahlende Fläche der Leuchte, Leuchtdiodeneinheit bzw. Leuchtdiode schneidet, oder zumindest keine solche Symmetrie in einer von zwei Halbebenen aufweist, welche in einer Ebene, die den oder einen lichtabstrahlenden Bereich der Leuchte, der Leuchtdiodeneinheit bzw. der Leuchtdiode schneidet, durch eine Gerade durch den besagten lichtabstrahlenden Bereich der Leuchte, der Leuchtdiodeneinheit bzw. der Leuchtdiode definiert werden. Diese Gerade kann insbesondere eine Gerade sein, die in der Ebene der Lichtaustrittsfläche oder in einer die Lichtaustrittsfläche approximierenden Ebene liegt, beispielsweise in einer Tangentialebene zu der Lichtaustrittsfläche.

Die Ebene, auf welche diese Lichtstärkeverteilungskurve bezogen ist, kann insbesondere eine Ebene sein, die senkrecht zu einer Fläche der Leuchte, Leuchtdiodeneinheit oder Leuchtdiode ist, über welche Licht abgestrahlt wird und/oder eine C-Ebene im Sinne von DIN 5032-1 sein. Wenn die Fläche, über welche das Licht abgestrahlt ist, nicht eben ist, kann dies z.B. eine Ebene sein, die lokal auf der Lichtaustrittsfläche senkrecht steht oder auf einer Ebene senkrecht steht, welche die Lichtaustrittsfläche approximiert, z.B. in dem Sinne, daß die Abweichungen der tatsächlichen Lichtaustrittsfläche von dieser Ebene klein oder (gemittelt über die Fläche) minimal sind.

Die Lichtabstrahlcharakteristik kann insbesondere in einer Ebene, welche den oder einen lichtabstrahlenden Bereich der Leuchte, der Leuchtdiodeneinheit bzw. der Leuchtdiode schneidet, bezüglich einer Geraden in dieser Ebene asymmetrisch sein, die auf der Lichtaustrittsfläche oder einer Ebene, welche die Lichtaustrittsfläche approximiert, senkrecht steht. In weiteren Ausführungsformen kann die Ebene, in welcher diese Lichtstärkeverteilungskurve definiert ist, eine Ebene senkrecht zu der Oberfläche des Trägerelements oder zu einer Approximation dieser Fläche durch eine Ebene, bzw., im Falle einer Leuchtdiodeneinheit oder eine Leuchtdiode, eine Ebene senkrecht zu der Befestigungsfläche oder eine Ebene, welche die Befestigungsfläche approximiert, sein. Eine asymmetrische Lichtabstrahlcharakteristik kann insbesondere eine solche Lichtabstrahlcharakteristik sein, bei welcher die Lichtverteilung in einer Schnittebene, in welcher die Hauptabstrahlrichtung der Leuchtdiode liegt und welche deren Lichtaustrittsfläche schneidet, eine Lichtverteilungskurve definiert, die ein bezüglich der Hauptabstrahlrichtung der Leuchtdiode asymmetrisches Maximum aufweist. Dieses Maximum kann insbesondere das einzige Maximum der Lichtstärkeverteilungskurve sein oder ein globales Maximum oder Hauptmaximum der Lichtstärkeverteilungskurve.

Die Erfindung hat verschiedene Vorteile. Dadurch, daß für verschiedene Lichtabstrahlcharakteristiken dasselbe Trägerelement, insbesondere dieselbe Leiterplatte verwendet werden kann, ist die Herstellung des Trägerelements in größeren Stückzahlen möglich. Da sich unterschiedliche Abstrahlcharakteristiken weitgehend unabhängig von der Orientierung des Trägerelements in der Leuchte realisieren lassen, muß das Trägerelement nicht dafür eingerichtet werden, in verschiedene Orientierungen oder Positionen in ein Gehäuse eingebaut zu werden. Es kann daher rechteckig oder in einer sonstigen einfachen Form ausgebildet sein, was die Fertigung vereinfacht. Durch die Variabilität des Ausstrahlwinkels kann flexibler auf konkrete Anforderungen reagiert werden, insbesondere im Projektbereich der Leuchtenentwicklung, in dem spezielle Leuchten für ein bestimmtes Projekt, z.B. ein bestimmtes Gebäude oder eine bestimmte Anlage konzipiert und gefertigt werden. Durch verschiedene Winkeleinstellungen verschiedener Leuchtdiodeneinheiten auf demselben Trägerelement kann die Lichtverteilung individuell und gezielt variiert werden, da die Beiträge der einzelnen Leuchtdiodeneinheiten zu der gesamten Lichtverteilung individuell variiert werden können.

Die Erfindung ist sowohl für Innenraumleuchten als auch für Außenleuchten einsetzbar. Im Bereich der Außenleuchten kann die Erfindung insbesondere bei der Straßenbeleuchtung und bei der großflächigen Beleuchtung von Plätzen oder anderen Geländeabschnitten eingesetzt werden, insbesondere bei Lichtflutern. Die Erfindung kann auch bei dekorativen Außenleuchten, beispielsweise bei Lichtpollern verwendet werden. Im Bereich der Innenleuchten kann die Erfindung überall da eingesetzt werden, wo eine gezielte Beleuchtung der Raumbereiche und/oder eine bestimmte Lichtstärkeverteilungskurve gefordert ist, beispielsweise bei Bildschirmarbeitsplatzleuchten, die eine bestimmte Lichtstärkeverteilungskurve aufweisen müssen, bei der Arbeitsplatzbeleuchtung oder bei der Spotbeleuchtung, wobei die Leuchtenform keinen wesentlichen Einschränkungen unterliegt. Eine erfindungsgemäße Innenraumleuchte kann insbesondere eine Hängeleuchte, Standleuchte, Deckeneinbauleuchte, Deckenanbauleuchte, Wallwasher, Ceilingwasher, Wandleuchte oder Tischleuchte sein.

Weitere Merkmale und Vorteile der Erfindung ergeben sich aus der nachfolgenden Beschreibung von Ausführungsbeispielen mit beispielhaftem Bezug auf dem "Footprint" einer Leuchtdiode vom Typ OSRAM Golden Dragon, wobei die Erfindung ohne weiteres auch auf andere Footprints und andere kommerziell erhältliche Leuchtdioden und Leuchtdiodeneinheiten anwendbar ist.
- Fig. 1: zeigt die Anordnung der Kontaktstellen an einer Montagestelle bei einer konventionellen Leiterplatte, die dem Footprint der LED entspricht.
- Fig. 2: zeigt das Muster der Kontaktstellen an einer Montagestelle einer erfindungsgemäßen Leiterplatte nach einer ersten Ausführungsform der Erfindung,
- Fig. 2a: zeigt schematisch die Montagestelle einer erfindungsgemäßen Leiterplatte nach Fig. 2, die mit einer Leuchtdiode in einer ersten Orientierung bestückt ist,
- Fig. 2b: zeigt die Montagestelle der erfindungsgemäßen Leiterplatte entsprechend Fig. 2, bei welcher die Montagestelle mit einer Leuchtdiode in einer zweiten Orientierung bestückt ist,
- Fig. 3: zeigt eine zweite Ausführungsform des Kontaktmusters an einer Montagestelle einer erfindungsgemäßen Leiterplatte,
- Fig. 3a: zeigt eine Montagestelle einer erfindungsgemäßen Leiterplatte gemäß der Ausführungsform der Fig. 3, welche mit einer Leuchtdiode in einer ersten Orientierung bestückt ist,
- Fig. 3b: zeigt eine Montagestelle einer erfindungsgemäßen Leiterplatte gemäß der Ausführungsform der Fig. 3, welche mit einer Leuchtdiode in einer zweiten Orientierung bestückt ist,
- Fig. 3c: zeigt eine Montagestelle einer erfindungsgemäßen Leiterplatte gemäß der Ausführungsform der Fig. 3, welche mit einer Leuchtdiode in einer dritten Orientierung bestückt ist,
- Fig. 4: zeigt eine dritte Ausführungsform des Kontaktmusters einer Montagestelle einer erfindungsgemäßen Leiterplatte,
- Fig. 4a: zeigt eine Montagestelle einer erfindungsgemäßen Leiterplatte gemäß Fig. 4, welche mit einer Leuchtdiode bestückt ist,
- Fig. 5: zeigt ein Kontaktmuster einer Montagestelle einer erfindungsgemäßen Leiterplatte nach einer vierten Ausführungsform der Erfindung,
- Fig. 6: zeigt eine weitere Ausführungsform der Erfindung mit einer verstellbaren, der Leuchtdiode zugeordneten Optik,
- Fig. 6a: zeigt die Optik bei der Ausführungsform gemäß Fig. 6 in einer ersten Position,
- Fig. 6b: zeigt die Optik gemäß der Ausführungsform nach Fig. 6 in einer zweiten Position,
- Fig. 6c: zeigt die Optik nach einer Ausführungsform der Fig. 6 in einer dritten Position und
- Fig. 6d: zeigt die Optik bei der Ausführungsform nach Fig. 6 in einer vierten Position,
- Fig. 7: zeigt eine Ausführungsform einer Montagestelle einer erfindungsgemäßen Leiterplatte gemäß einer weiteren Ausführungsform, bei welcher die Orientierung der Optik stufenlos gegenüber der Leuchtdiode in der Befestigungseinrichtung verstellt werden kann.
- Fig. 8: stellt schematisch ein Ausführungsbeispiel einer erfindungsgemäßen Leuchte dar,
- Fig. 9: zeigt die Lichtstärkeverteilungskurve, die von einem Paar von symmetrisch zu der Mittelebene der Leuchte angeordneten Leuchtdiodeneinheiten erzeugt wird,
- Fig. 10: zeigt schematisch eine Kegelmantelkurve der Lichtstärkeverteilung bei einer Anordnung von Leuchtdiodeneinheiten, bei der die Hauptabstrahlrichtung jeweils senkrecht zu der Mittenebene E der Leuchte ausgebildet ist,
- Fig. 11: illustriert die Hauptabstrahlrichtungen der Leuchtdiodeneinheiten der Ausfiihrungsform der erfindungsgemäßen Leuchte gemäß Fig. 8,
- Fig. 12: illustriert eine Kegelmantelkurve der Lichtstärkeverteilung der Leuchte gemäß Fig. 8.

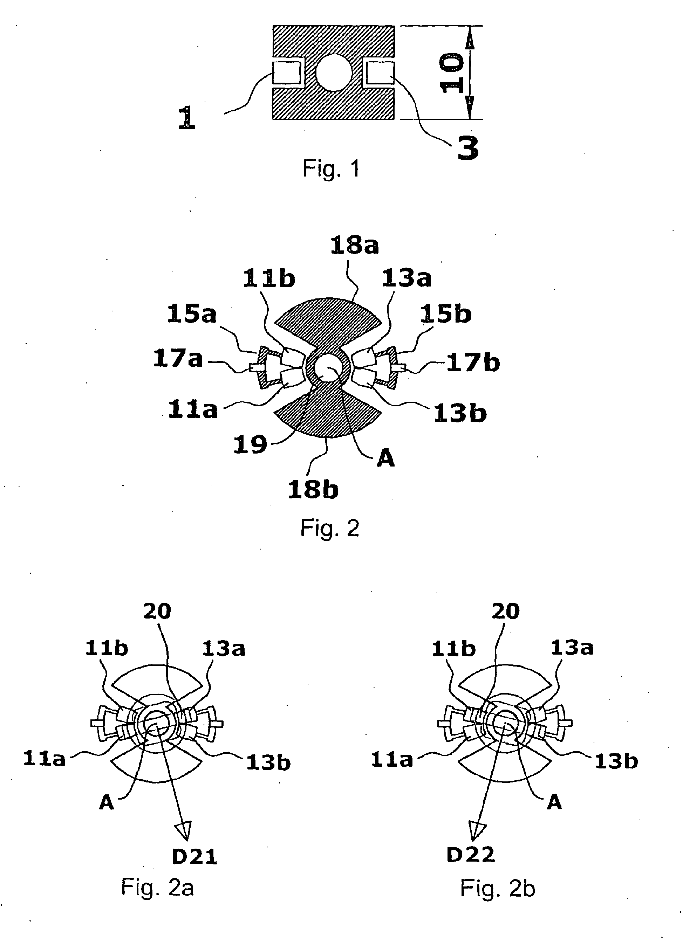

Bei den beschriebenen Ausführungsbeispielen wird davon ausgegangen, daß die Leuchtdiode zwei einander gegenüberliegende Kontaktelemente aufweist, zu deren Kontaktierung zwei Kontaktstellen 1 und 3 auf einer zugehörigen Leiterplatte erforderlich sind, wie in Fig. 1 gezeigt. Die Kontaktstellen 1 und 3 haben eine Kupferoberfläche. Der restliche Bereich der Montagestelle (schwarz dargestellt) ist mit einem Lötstopplack abgedeckt, wobei sich unterhalb des Lötstopplacks eine Kupferschicht befinden kann. Gegebenenfalls können die Kontaktstellen dadurch realisiert werden, daß eine Kupferschicht mit einem Lötstopplack derart beschichtet wird, daß nur die Kontaktstellen 1 und 3 frei bleiben.

Bei der Ausführungsform einer erfindungsgemäßen Leiterplatte nach Fig. 2 sind zwei Paare von Kontaktstellen 11a und 13a bzw. 11b und 13b vorgesehen, wobei sich die Kontaktstellen eines Paares diametral einander gegenüber liegen. Jedes Paar 11a, 13a und 11b, 13b entspricht der Anordnung der Kontaktelemente (Footprint) der anzubringenden LED, so daß diese wahlweise mit dem ersten Paar (11a, 13a) oder mit dem zweiten Paar (11b, 13b) kontaktiert werden kann. Von den Kontaktstellen 11a und 11b führen jeweils mit Lötstopplack (schwarz dargestellt) abgedeckte, radial verlaufende Leiterbahnen zu einem kreisbogenförmigen Leiterbahnabschnitt 15a, der wiederum, bis auf eine Kontaktstelle 17a, mit Lötstopplack abgedeckt ist. Symmetrisch hierzu erstrecken sich von den Kontaktstellen 13a und 13b von Lötstopplack abgedeckte, radial verlaufende Leiterbahnen zu einem zweiten, kreisbogenförmigen Leiterbahnabschnitt 15b, der ebenfalls bis auf eine Kontaktstelle 17b mit Lötstopplack abgedeckt ist. In beiden Fällen stehen die Kontaktstellen 17a und 17b radial von der Leiterbahn 15a bzw. 15b nach außen vor, um die weitere Kontaktierung zu vereinfachen.

Wie man anhand von Fig. 2 erkennt, ist die gesamte Anordnung an der Montagestelle kreisförmig, wobei die Kontaktstellen 11a, 11b mit den zugehörigen Leiterbahnen bzw. die Kontaktstellen 13a und 13b sowie die zugehörigen Leiterbahnen jeweils in einem Kreissektor liegen. Die restlichen Sektoren dieses Kreises 18a und 18b bestehen aus einer Kupferschicht, die mit Lötstopplack abgedeckt ist.

Die Lage der Kontaktstellenpaare 11b und 13b ergibt sich aus der Lage der Kontaktstellen 11a und 13a durch eine Rotation um 30° bezüglich des Zentrums der kreisförmigen Anordnung der Montagestelle, d.h. um die senkrecht zu der Zeichenebene verlaufende Achse A.

Im Zentrum der Montagestelle ist eine thermische Verbindungsstelle 19 vorgesehen, welche in thermischem Kontakt mit der Kupferschicht in den Kreissektoren 18a und 18b steht. Bei der Montage einer Leuchtdiodeneinheit kann hier ein thermischer Kontaktpunkt einer Leuchtdiodeneinheit, insbesondere einer Leuchtdiode, vorzugsweise durch Löten, befestigt werden, so daß eine thermisch leitende Verbindung zwischen der Kupferschicht der Kreissektoren 18a und 18b und der thermischen Verbindungsstelle der Leuchtdiodeneinheit hergestellt wird, die ihrerseits wiederum in einer thermisch leitenden Verbindung mit Wärmequellen der Leuchtdiodeneinheit steht. Gemäß einer bevorzugten Ausführungsform sind die Kontaktstellen 19 und die Kupferschicht in den Kreissektoren 18a und 18b mit einem Kühlkörper (nicht dargestellt) auf der der Montagestelle gegenüberliegenden Seite des Trägerelements, insbesondere der Leiterplatte, thermisch gekoppelt. Dies läßt sich beispielsweise dadurch realisieren, daß die Leiterplatte insgesamt aus Metall besteht und dementsprechend thermisch leitend ist. In einer bevorzugten Ausführungsform, in welcher das Material des Trägerelementes schlecht wärmeleitend ist, insbesondere wenn das Trägerelement im wesentlichen aus einer Kunststoffplatte besteht, können im Bereich der Kreissektoren 18a und 18b und/oder im Bereich der thermischen Verbindungsstelle 19 thermisch leitende Elemente in Draht- oder Röhrenform, sogenannte "thermal vias" vorhanden sein, welche das Trägerelement durchsetzen und eine thermische Verbindung zwischen der Seite des Trägerelements, auf der sich die Montagestelle befindet, und der gegenüberliegenden Seite des Trägerelements herstellen, wobei der besagte Kühlkörper auf der der Montagestelle gegenüberliegenden Seite mit diesen thermisch leitenden Elementen thermisch gekoppelt ist, so daß er die über diese thermisch leitenden Elemente transportierte Wärme abführen kann. Diese wärmeleitenden Elemente können in einem oder beiden der Kreissektoren 18a und 18b und/oder im Bereich der thermischen Verbindungsstelle 19 vorhanden sein.

Fig. 2a zeigt eine Montagestelle gemäß Fig. 2, die mit einer Leuchtdiode 20 bestückt ist, die an dem ersten Paar von Kontaktstellen 11a, 13a kontaktiert ist. Die Leuchtdiode ist dabei um einen Winkel von +15° aus der Normallage (0°) um die Achse A gedreht. Diese Leuchtdiode weist eine asymmetrische Lichtabstrahlung auf, wobei die Hauptabstrahlrichtung in der Projektion auf die Ebene der Leiterplatte durch den Pfeil D₂₁ dargestellt ist. Fig. 2b zeigt die gleiche Montagestelle, bei der die LED an dem zweiten Paar 11b, 13b von Kontaktstellen kontaktiert ist und damit gegenüber der Lage der Leuchtdiode gemäß Fig. 2a um 30° (-15° zu der Normallage) um die Achse A gedreht ist. Die Hauptabstrahlrichtung der Leuchtdiode ist durch den Pfeil D₂₂ angegeben.

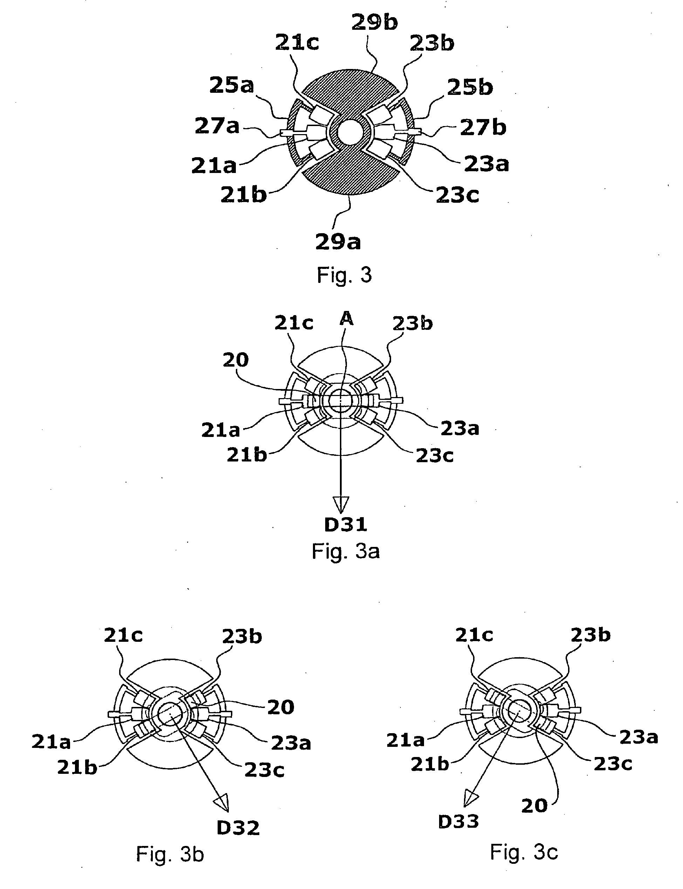

Fig. 3 zeigt eine Abwandlung der Ausführungsform gemäß Fig. 2, bei welcher drei Paare von Kontaktstellen, die jeweils dem Footprint einer LED entsprechen, in zueinander um 30° bezüglich der Achse A gedrehten Positionen vorgesehen sind, nämlich ein erstes Paar 21a, 23a, welches der Normallage der LED (0°) entspricht, ein zweites Paar 21b, 23b, welches der um +30° aus der Normallage um die Achse A gedrehten Lage der LED entspricht und ein drittes Paar 21c, 23c, welches der um -30° aus der Normallage um die Achse A gedrehten Lage der LED entspricht. Die Kontaktstellen 21b und 21c einerseits und die Kontaktstellen 23b und 23c andererseits sind jeweils durch radial verlaufende Leiterbahnabschnitte, die mit Lötstopplack abgedeckt sind, mit einem in Umfangsrichtung verlaufenden kreisbogenförmigen Leiterbahnabschnitt 25a bzw. 25b verbunden, der, bis auf eine sich von ihm radial nach außen erstreckende Kontaktstelle 27a bzw. 27b, ebenfalls mit Lötstopplack abgedeckt ist. Die Kontaktstellen 21a und 23a sind durch eine nicht abgedeckte, radial verlaufende Leiterbahn ebenfalls mit der Kontaktstelle 27a bzw. 27b verbunden. Die restlichen Sektoren 29a und 29b der Anordnung der Montagestelle bestehen wieder aus einer Kupferschicht, die mit Lötstopplack abgedeckt ist.

Die zugehörigen Montagemöglichkeiten sind in den Fig. 3a bis 3c dargestellt, wobei die Pfeile D₃₁, D₃₂ und D₃₃ die jeweiligen Hauptabstrahlrichtungen der LED, projiziert auf die Leiterplatte, angeben.

In der Stellung der Fig. 3a befindet sich die Leuchtdiode in der Normalstellung (0°). Ihre Kontaktelemente sind mit den Kontaktstellen 21 a und 23a verbunden. In der Montagestellung der Fig. 3b ist die LED gegenüber der Normalstellung um 30° gedreht montiert. Ihre Kontaktelemente sind mit den Kontaktstellen 21b und 23b verbunden. In der Ausführungsform der Fig. 3c ist die Leuchtdiode gegenüber der Normalstellung um -30° gedreht dargestellt, wobei die Kontaktelemente mit den Kontaktstellen 21c und 23c verbunden sind. Entsprechend liegt die (auf die Leiterplatte projizierte) Hauptabstrahlrichtung bei 0° (Fig. 3a), +30° (Fig. 3b) und -30° (Fig. 3c).

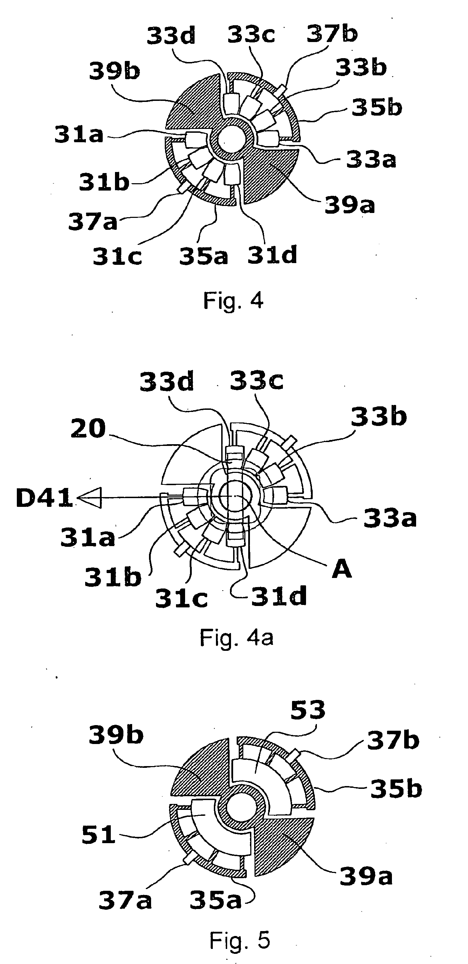

Die Ausführungsform einer Montagestelle gemäß Fig. 4 ist ähnlich zu den Ausführungsformmen der Fig. 2 und 3 aufgebaut. Es gibt hier vier Paare von Kontaktstellen (31a, 33a; 31b, 33b; 31c, 33c; 31d, 33d), welche der Normalstellung der Leuchtdiode (0°) und den hierzu um 30°, 60° bzw. 90° gedrehten Stellungen entsprechen. Wie bei den anderen Ausführungsformmen ist jede der Kontaktstellen über radiale, mit Lötstopplack abgedeckten Leiterbahnen mit einem kreisbogenförmigen Leiterbahnabschnitt 35a bzw. 35b verbunden, der ebenfalls, bis auf sich radial nach außen erstreckenden Kontaktflächen 37a bzw. 37b, mit Lötstopplack bedeckt ist. Fig. 4a zeigt eine Montagestelle gemäß Fig. 4, bei welcher die Leuchtdiode in der zu der Normalposition um 90° gedrehten Position aufgesetzt und mit den Kontaktstellen 31 d und 33d verbunden ist. Die Hauptabstrahlrichtung, projiziert auf die Leiterplatte, ist mit dem Pfeil D₄₁ bezeichnet. Auch hier bestehen die restlichen Sektoren der Montagestelle 39a und 39b aus einer Kupferschicht, die mit Lötstopplack abgedeckt ist.

Bei den vorangehend beschriebenen Ausführungsformen ist für jede mögliche Stellung der Leuchtdiode ein separates Paar von Kontaktstellen vorgesehen. Diese Kontaktstellen haben, insbesondere in Umfangsrichtung, eine relativ kleine Ausdehnung. Auf diese Weise kann die Fläche dieser Kontaktstellen kleingehalten werden. Dies ist vorteilhaft, wenn die LED in einem Reflow-Lötprozeß oder einem verwandten Lötprozeß mit den Kontaktstellen verlötet wird, da auf diese Weise eine mögliche Positionsänderung während des Lötprozesses aufgrund eines Veschwimmens der LED kleingehalten werden kann.

Eine Abwandlung der Ausführungsform der Fig. 4 ist in Fig. 5 gezeigt. In dieser Ausführungsform sind identische Elemente mit den gleichen Bezugszeichen wie bei der Ausführungsform der Fig. 4 bezeichnet. Anstelle von zwei Gruppen von vier einzelnen Kontaktstellen ist bei dieser Ausführungsform nur ein Paar von bogenförmigen Kontaktflächen 51 und 53 vorgesehen, die sich jeweils über einen Viertelkreis erstrecken und über vier radial sich nach außen erstreckende, mit Lötstopplack abgedeckte Leiterbahnen zu den radial weiter außen liegenden kreisbogenförmigen Leiterbahnabschnitten 35a bzw. 35b erstrecken, welche die Kontaktstellen 37a und 37b aufweisen. Bei dieser Ausführungsform muß sichergestellt sein, daß sich die LED im Augenblick des Lötens nicht verschiebt oder dreht, beispielsweise durch unterschiedliche Erwärmung der Leiterbahnen. Sofern dies nicht durch das verwendete Lötverfahren oder eine geeignete Prozeßführung bzw. durch die Verwendung geeigneter Lötmittel gewährleistet werden kann, ist denkbar, während des Lötprozesses eine Haltevorrichtung einzusetzen, welche die Leuchtdioden in ihrer vorgegebenen Orientierung hält.

Die vorangehend dargestellten Kontaktmuster sind lediglich beispielhaft. Darüber hinaus können auf einem Trägerelement, insbesondere auf einer Leiterplatte, auch unterschiedliche Kontaktmuster, beispielsweise die Muster der Fig. 2, 3 und/oder 4, je nach Aufgabenstellung und Bedarf, kombiniert werden. Kontaktmuster können sowohl symmetrisch zu einer Normallage sein (vgl. Fig. 2 und 3) als auch asymmetrisch (d.h. einseitig, vgl. Fig. 4 und 5).

Eine thermische Verbindungsstelle, wie sie in Zusammenhang mit der Ausführungsform der Fig. 2 erläutert wurde, kann insbesondere auch bei allen anderen Ausführungsformen vorhanden sein, wie sie in Fig. 3 bis 5 gezeigt sind. Diese thermische Verbindungsstelle kann in der gleichen Weise, wie für die Ausführungsform der Fig. 2 beschrieben, mit der unter einer Lötstopplackschicht liegenden Kupferschicht in den Kreissektoren 29a und 29b bzw. 39a und 39b liegen und in der vorangehend beschriebenen Weise mit einem Kühlkörper auf der der Montagestelle gegenüberliegenden Stelle der Leiterplatte thermisch gekoppelt sein. Die Schichten unter den Lötstopplackschichten in den Kreissektoren 18a, 18b, 29a, 29b oder 39a, 39b müssen nicht notwendigerweise aus Kupfer bestehen, sondern können auch aus einem anderen wärmeleitenden Material bestehen. Anstelle eines Kühlkörpers kann auch vorgesehen sein, daß die Leiterplatte selbst oder auf ihr ausgebildete Schichten aus einem wärmeleitenden Material mit einer die Wärmeabfuhr begünstigenden Struktur, beispielsweise in Rippen- oder Wellform, ausgebildet ist.

Zur Herstellung wird eine LED mit einem Bestückungsautomaten in dem gewünschten Winkel entsprechend der vorgegebenen bzw. gewünschten Position auf der vorbereiteten Leiterplatte plaziert und sodann durch einen Lötvorgang, beispielsweise einen Reflow-Lötvorgang, fixiert. Das Plazieren auf der Leiterplatte kann durch einen Pick-and-Place-Roboter erfolgen.

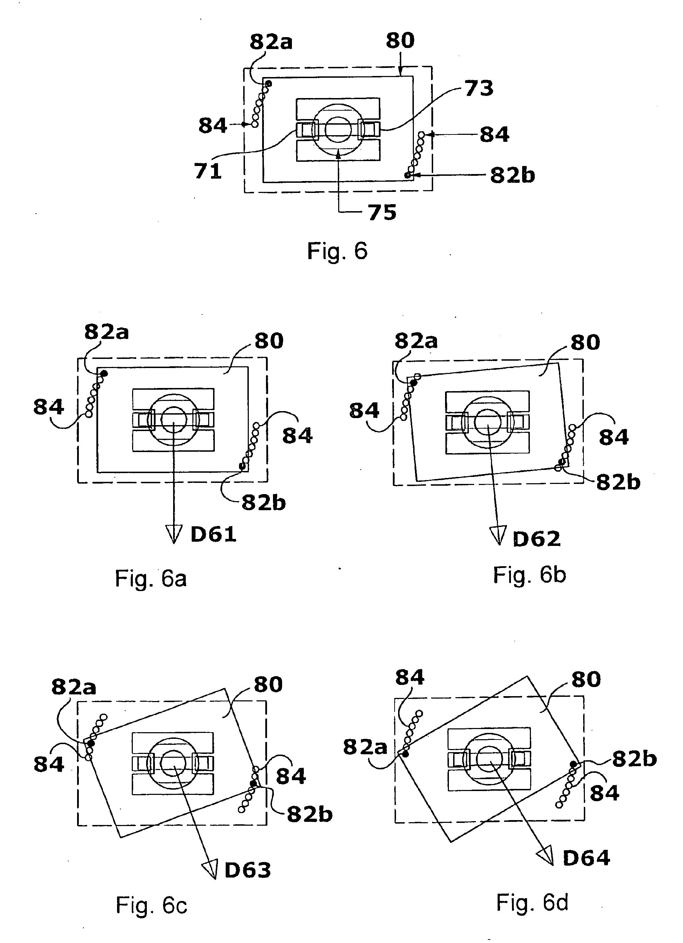

In Fig. 6 ist ein weiterer Aspekt der Erfindung illustriert. Bei der dargestellten Ausführungsform besitzt die Montagestelle der Leiterplatte nur ein Paar von Kontaktstellen 71 und 73, auf denen dementsprechend eine Leuchtdiode 75 nur in einer Position montiert werden kann. Über der Leuchtdiode 75 ist eine optische Anordnung in Form eines optischen Bauelements 80 angeordnet, welches an seinem Rand an zwei einander gegenüberliegenden Ecken zwei Führungszapfen 82a und 82b aufweist. Die Leiterplatte weist hierzu korrespondierende Positionslöcher 84 auf, die in zwei Gruppen einander diametral gegenüberliegend jeweils auf einer Kreisbogenlinie in gleichen Winkelabständen vorgesehen sind.

Bei der Ausführungsform der Fig. 6 erzeugt oder verändert die optische Anordnung des Bauelements 80 die asymmetrische Lichtverteilung. Gemäß einer ersten Ausführungsform gibt die Leuchtdiode selbst das Licht mit einer symmetrischen Lichtverteilung ab und die optische Anordnung erzeugt hieraus eine asymmetrische Lichtverteilung, beispielsweise mit einer bestimmten Vorzugsrichtung. In einer alternativen Ausführungsform kann vorgesehen sein, daß die Leuchtdiode selbst bereits eine asymmetrische Lichtverteilung aufweist, wobei die optische Anordnung des Bauelements 80, je nach ihrer Lage, die Lichtverteilung ändert.

Durch Einführen der Führungszapfen 82a und 82b in ein Paar von einander diametral gegenüberliegenden Positionslöchern 84 der Leiterplatte kann das optische Bauelement 80 in verschiedenen, zueinander gedrehten Positionen fixiert werden, was in den Fig. 6a bis 6d illustriert ist. Fig. 6a, bei der die Führungszapfen 82a und 82b in die jeweiligen äußersten Positionslöcher der Leiterplatte eingesteckt sind, zeigt die optische Anordnung in ihrer Normallage (0°). Fig. 6b, bei welcher die Führungszapfen in das in Umfangsrichtung nächste Paar von Positionslöchern der Leiterplatte eingesteckt sind, zeigt das optische Bauelement in einer um 5° gedrehten Position. In Fig. 6c ist das optische Bauelement gegenüber der Normallage der Fig. 6a um 20° und Fig. 6d um 30° gedreht.

In den Fig. 6a bis 6d sind die Hauptabstrahlrichtungen, projiziert auf die Ebene der Leiterplatte, mit den Pfeilen D₆₁, D₆₂, D₆₃ und D₆₄ bezeichnet. Man erkennt, daß eine Drehung des optischen Bauelements 80 zu einer entsprechenden Drehung der Hauptabstrahlrichtung um 5°, 20° bzw. 30° gegenüber der Normallage des optischen Bauelements führt.

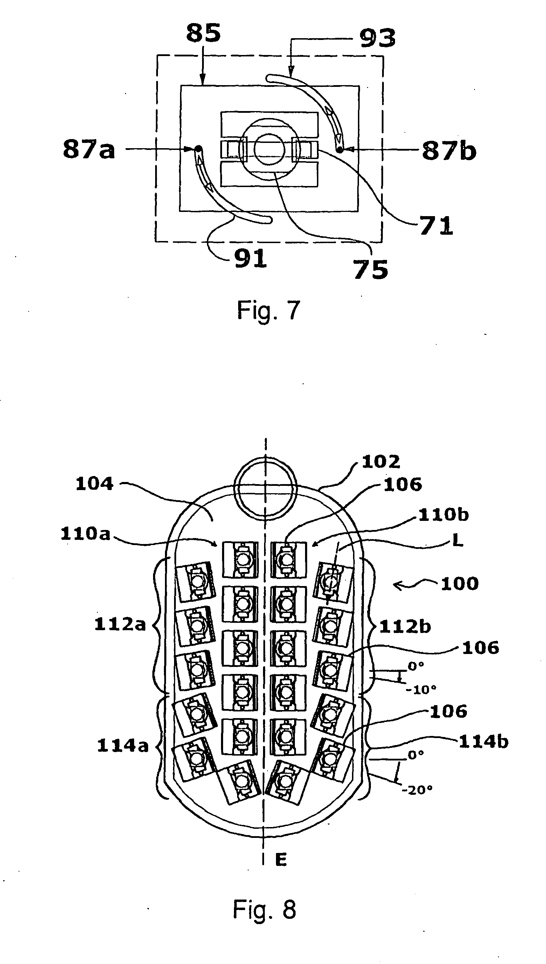

In einer Abwandlung dieser Ausführungsform, die in Fig. 7 dargestellt ist, weist ein optisches Bauelement 85 wieder einander diametral gegenüberliegende Führungszapfen 87a, 87b auf. Die Leiterplatte besitzt bei dieser Ausführungsform jedoch keine diskreten Positionslöcher, sondern zwei kreisbogenförmige Schlitze 91 und 93, in welche die Führungszapfen 87a und 87b eingreifen, so daß das optische Bauelement 85 kontinuierlich in den Schlitzen 91 und 93 verdreht werden kann. In der gewünschten Position wird das optische Bauelement dann in geeigneter Weise, beispielsweise durch Kleben, fixiert.

Ein optisches Bauelement, das bei einer Ausführungsform der Erfindung mit unterschiedlichen Orientierungen montiert werden kann, wie in Fig. 6 oder 7 illustriert, kann seinerseits auch aus mehreren Teilen bestehen, die z.B. vor der Montage auf dem Trägerelement zusammengesetzt werden.

Während bei den vorangehend beschriebenen Ausführungsformen die Leuchtdiode an der Montagestelle nur in einer Orientierung montiert werden kann, kann erfindungsgemäß auch vorgesehen sein, daß sowohl die optische Anordnung als auch die Leuchtdiode in verschiedenen Positionen montiert werden können, was die Zahl der Variationsmöglichkeiten hinsichtlich der Hauptabstrahlrichtung noch vergrößert. Auch hier können auf einer Leiterplatte verschiedene Ausführungsformen von Kontaktmustern und/oder Befestigungsvorrichtungen für optische Anordnungen kombiniert werden.

Während bei den vorangehend beschriebenen Ausführungsformen der Fig. 6 und Fig. 7 die optische Anordnung, welche die asymmetrische Lichtverteilung erzeugt oder diese im Sinne einer Rotation verändert, nur ein optisches Bauelement umfaßt, das mittels der Führungszapfen 82a und 82b bzw. 87a und 87b und Positionslöchern 84 bzw. Schlitzen 91 und 93 in unterschiedlichen Orientierungen eingesetzt werden kann, kann erfindungsgemäß auch vorgesehen sein, daß die einer Leuchtdiode 75 zugeordnete optische Anordnung durch mehrere optische Bauelemente gebildet wird. In diesem Fall kann vorgesehen sein, daß eines, mehrere oder alle dieser optischen Bauelemente jeweils mit verschiedenen Orientierungen auf dem Trägerelement montiert werden können. Beispielsweise kann vorgesehen sein, daß jedes dieser Bauelemente Führungszapfen, wie die Führungszapfen 82a, 82b oder 87a, 87b aufweist, die in entsprechende Positionslöcher oder Schlitze eingreifen. Hierbei muß nicht notwendigerweise jedem optischen Bauelement eine Gruppe von Befestigungslöchern oder Schlitzen eindeutig zugeordnet sein. Es kann beispielsweise auch vorgesehen sein, daß eine Anordnung von Befestigungslöchern und/oder Schlitzen für die Positionierung aller solcher optischen Bauelemente genutzt wird.

Während bei der Ausführungsform der Fig. 6 Positionslöcher und bei der Ausführungsform der Fig. 7 Schlitze zum Positionieren des optischen Bauelementes verwendet wurden, können in anderen Ausführungsformen auch Positionslöcher und Schlitze kombiniert werden.

In Fig 8 ist als ein Beispiel einer erfindungsgemäßen Leuchte eine Leuchte 100 dargestellt, die beispielsweise als Straßenleuchte ausgebildet sein kann, welche ein Leuchtengehäuse 102 und eine Leiterplatte 104 aufweist, auf welcher Leuchtdiodeneinheiten 106 montiert sind und welche im wesentlichen senkrecht zu den Seitenwänden des Gehäuses 102 verläuft. Über der Anordnung von Leuchtdioden 106 ist eine lichtdurchlässige Abdeckung (nicht dargestellt), beispielsweise in Form einer Leuchtenwanne vorgesehen, welche auf das Gehäuse 100 aufgesetzt oder anderweitig mit diesem so verbunden wird, daß durch die Leuchtenabdeckung und das Leuchtengehäuse ein abgeschlossener Raum gebildet wird, in welchem die Trägerplatte 104 mit den darauf angebrachten Leuchtdiodeneinheiten 106 angeordnet ist. Das Gehäuse und/oder die Leuchtenabdeckung kann Durchlässe zum Druck- und/oder Wärmeausgleich mit der Umgebung aufweisen oder anderweitig eine Einrichtung zum Abführen der in dem von der Leuchtenwanne und dem Leuchtengehäuse umschlossenen Raumbereich erzeugten Wärme aufweisen.

Die in Fig. 8 gezeigten Leuchtdiodeneinheiten 106 haben eine asymmetrische Lichtabstrahlcharakteristik in dem Sinne, daß sie, bezogen auf eine Ebene senkrecht zu ihrer Lichtaustrittsfläche bzw. ihren Lichtaustrittsflächen, und/oder auf eine Ebene senkrecht zu der Längsachse L der Leuchtdiodeneinheiten, welche die beiden Kontaktelemente der Leuchtdiodeneinheit verbindet, in dem Sinne asymmetrisch ist, daß die Lichtstärkeverteilungskurve ein einseitiges Maximum aufweist. Im konkreten Fall der Fig. 8 gibt es zwei bezüglich der Ebene E symmetrische Maxima, die jeweils von der Ebene E weg, also in Richtung einer Seitenwand des Gehäuses 102 weisen. Die Leuchtdiodeneinheiten sind auf jeder Seite der Mittenebene E der Leuchte 100 in sechs Gruppen 110a bzw. 110b, 112a und 112b sowie 114a und 114b angeordnet. Dabei bestehen die Gruppen 110a und 110b jeweils aus fünf Leuchtdiodeneinheiten, welche in einer Reihe parallel zu der Mittenebene E derart angeordnet sind, daß ihre Längsachsen L ebenfalls parallel zu der Mittenebene E sind. Die Gruppen 112a und 112b bestehen jeweils aus drei Leuchtdioden, die ebenfalls in einer Reihe parallel zu der Ebene E angeordnet sind, wobei jedoch ihre Längsachsen L jeweils mit der Ebene E einen nicht verschwindenden Winkel einschließen. Die Leuchtdiodeneinheiten der Gruppe 114a bzw. 114b sind jeweils auf einer bogenförmigen Linie, die etwa einer Viertelellipse oder einem Viertelkreis entspricht, angeordnet und weisen zueinander parallele Längsachsen L auf, deren Winkel zu der Mittenebene E von demjenigen Winkel verschieden ist, den die Längsachse der Leuchtdiodeneinheiten der Gruppe 112a und 112b mit der Mittenebene einschließt.

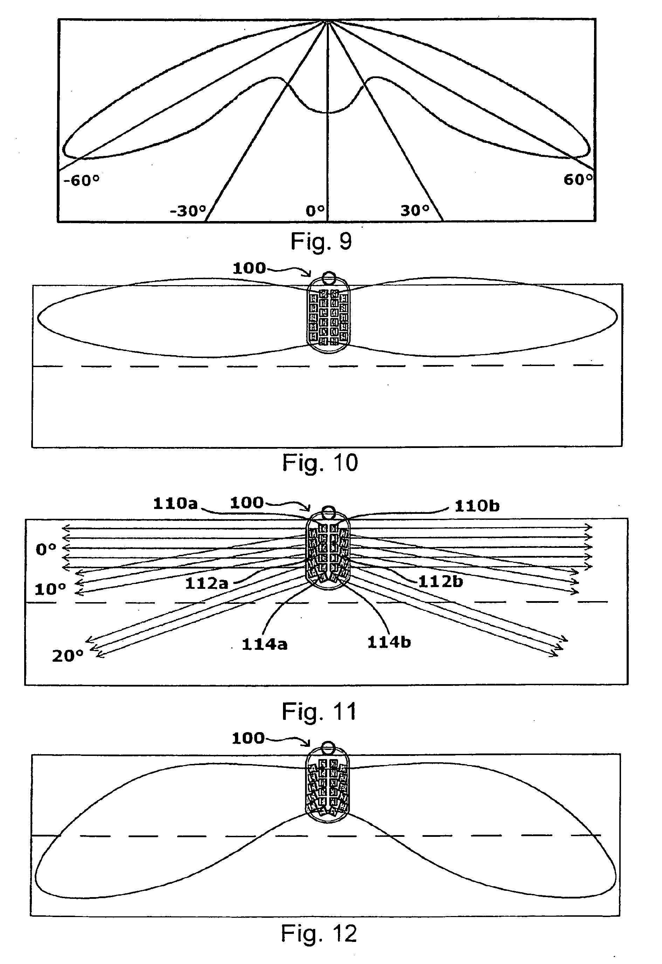

Die Leuchtdiodeneinheiten 106 sind so ausgebildet, daß sie, bezogen auf eine Ebene senkrecht zu ihrer Lichtabstrahlfläche und zu der Längsachse L ein Hauptmaximum bei etwa 60° besitzen und ein Nebenmaximum bei etwa 0°. Durch die symmetrische Anordnung der Leuchtdioden der beiden Gruppen 110a und 110b ergibt sich für diese beiden Leuchtdiodengruppen zusammengenommen einer Lichtstärkeverteilungskurve, wie sie in Fig. 9 dargestellt ist, nämlich mit zwei symmetrischen Maxima bei etwa 60° und einem zentralen Nebenmaximum bei etwa 0°. Wären nur diese beiden Gruppen 110a und 110b vorhanden, ergäbe sich hierbei eine Lichtstärkeverteilung der gesamten Leuchte, wie sie in Fig. 10 dargestellt ist. Fig. 10 zeigt eine Kegelmantelkurve der Lichtstärkeverteilung einer Leuchte, welche als Lichtquelle eine Anordnung von vier parallelen Reihen von asymmetrisch abstrahlenden Leuchtdiodeneinheiten aufweist, wobei diese Reihen von Leuchtdiodeneinheiten parallel zu der Mittenebene E der Leuchte sind und die Hauptabstrahlrichtung der Leuchtdiodeneinheiten, bezogen auf eine Projektion auf die Leiterplatte, welche die Leuchtdioden trägt, senkrecht zu der Mittenebene der Leuchte verläuft. Diese Kegelmantelkurve stellt in einem Polardiagramm die Lichtstärke dar, die sich in jeder C-Ebene für einen vorgegebenen Abstrahlwinkel zur Vertikalen für diese C-Ebene ergibt. Jeder Wert des in Fig. 10 aufgetragenen Winkels entspricht jeweils einer bestimmten C-Ebene. Der besagte vorgegebene Abstrahlwinkel ist für alle C-Ebenen gleich. Er ist für das Diagramm der Fig. 10 so gewählt, daß er der Lage eines Maximums der Lichtstärke in einer bestimmten C-Ebene entspricht, deren Lichtstärkeverteilungskurve in Fig. 9 dargestellt ist, und dementsprechend etwas mehr als 60° beträgt. Im konkreten Fall ist dies die C-Ebene, in der das Maximum der Lichtstärke den größten Wert hat.

In Fig. 10 ist zur Illustration ein skizzierter Straßenabschnitt unterlegt, der zwei jeweils in Längsrichtung verlaufende benachbarte Abschnitte aufweist, deren Grenze durch eine gestrichelte Linie angedeutet ist. Man erkennt anhand von Fig. 10, daß für einen festen Abstrahlwinkel zur Vertikalen die Lichtstärke in der Ebene senkrecht zur Leuchtenmittenebene E am größten ist und in einer C-Ebene parallel zu der Mittenebene am kleinsten. Insgesamt weist die Lichtstärkeverteilungskurve der Fig. 10 zwei langgestreckte Keulen auf, deren mittlere Richtung oder Symmetrieachse senkrecht zu der Mittenebene E ist und die daher insbesondere geeignet sind, einen streifenförmigen Geländeabschnitt, wie beispielsweise eine Straße oder einen Teil einer Straße, auszuleuchten.

Dadurch, daß die weiteren Gruppen von Leuchtdiodeneinheiten 112a und 112b, 114a und 114b vorhanden sind, wird jedoch die Lichtabstrahlcharakteristik der gesamten Leuchte dahingehend verändert, daß Lichtanteile schräg zur Mittelebene der Leuchte abgegeben werden, wie dies in Fig. 11 schematisch illustriert ist. In Fig. 11 sind jeweils die Hauptabstrahlrichtungen der Leuchtdiodeneinheiten 106 schematisch dargestellt. Die Hauptabstrahlrichtung der Leuchtdiodeneinheiten 110a und 110b, schließt in einer Projektion auf die Ebene der Leiterplatte 104, mit einer Senkrechten zu der Mittelebene E einen Winkel von 0° ein, die Hauptabstrahlrichtungen der Leuchtdiodeneinheiten der Gruppen 112a und 112b einen Winkel von 10° und die Hauptabstrahlrichtung der Leuchtdiodeneinheiten der Gruppen 114a und 114b einen Winkel von 20°. Dadurch wird die in Fig. 10 dargestellte Lichtstärkeverteilung dahingehend modifiziert, daß die beiden "Keulen" der Lichtstärkeverteilung so in ihrer Form geändert werden und modifiziert werden, daß ihre mittlere Richtung schräg zu der Mittenebene E verläuft, wie in Fig. 12 dargestellt. Fig. 12 zeigt eine Kegelmantelkurvendarstellung der Lichtstärke entsprechend der Fig. 10 für die Leuchten gemäß Fig. 8, wobei der Abstrahlwinkel zur Vertikalen, für den die Lichtstärke in den verschiedenen C-Ebenen aufgetragen ist, in beiden Fällen gleich ist. Bei der Lichtstärkeverteilungskurve der Fig. 12 ist die Lichtstärke bezüglich der Mittenebene E der Leuchte symmetrisch. Die Maxima der Lichtstärke sind jedoch mit einem Winkel von etwa 15° bezüglich einer Senkrechten zu der Mittelebene nach vorne verlagert. Durch diese Lichtbandknickung läßt sich beispielsweise eine Straße gleichmäßig über ihrer Breite beleuchten, auch wenn die Leuchte selbst an einer Längsseite der Straße montiert ist. Durch eine Vielzahl von derartigen Leuchten, die jeweils eine Lichtbandknickung, wie sie in Fig. 12 dargestellt ist, aufweisen, kann die Straße über ihre Länge und Breite nahezu gleichmäßig ausgeleuchtet werden.

Die Beleuchtungsstärkeverteilung der Fig. 12 ist lediglich beispielhaft. Bei einer erfindungsgemäßen Leuchte kann beispielsweise vorgesehen sein, daß die Längsachse L aller Leuchtdiodeneinheiten parallel sowohl zueinander als auch zu der Mittelebene der Leuchte ist, so daß sich insgesamt eine Lichtstärkeverteilung wie in Fig. 10 gezeigt ergibt. Derartige Leuchten können beispielsweise verwendet werden, wenn nur eine Straßenseite beleuchtet werden soll oder die Leuchte mittig über einer Fahrbahn angebracht ist.

Aus dem Vorangehenden ist ersichtlich, daß die Lichtbandknickung bei gleicher Leiterplatte 106 dadurch variiert werden kann, daß die Leuchtdioden der Gruppen 112a und 112b bzw. 114a und 114b in einem anderen Winkel zu der Mittenebene E der Leuchte orientiert werden. Für andere Anwendungen können auch die Leuchtdiodeneinheiten der Gruppen 110a und 110b anders als in Fig. 8 gezeigt orientiert sein, beispielsweise derart, daß ihre Längsachsen L jeweils zwar parallel zueinander sind, aber jeweils einen nicht verschwindenden Winkel mit der Mittenebene E einschließen. Ebenso kann auch die Anzahl der LED in der Leuchte insgesamt und/oder die Anzahl der LED in den verschiedenen Gruppen, in denen die LED jeweils dieselbe Hauptabstrahlrichtung besitzen (vgl. Fig. 11) variieren. Die Verteilung der LED in der Leuchte und/oder in den Gruppen muß auch nicht symmetrisch zu der Mittenebene der Leuchte sein.

Die in der vorangehenden Beschreibung, den Ansprüchen und den Zeichnungen offenbarten Merkmale der Erfindung können sowohl allein als auch in beliebiger Kombination für die Realisierung der Erfindung in ihren verschiedenen Ausführungsformen wesentlich sein.

### Bezugszeichenliste

- 1: Kontaktstelle
- 3: Kontaktstelle
- 11 a, 11 b: Kontaktstelle
- 13a, 13b: Kontaktstelle
- 15a, 15b: Leiterbahnabschnitt
- 17a, 17b: Kontaktstelle
- 18a, 18b: Kreissektor
- 19: thermische Verbindungsstelle
- 20: Leuchtdiode
- 21 a, 21 b, 21 c: Kontaktstelle
- 23a, 23b, 23c: Kontaktstelle
- 25a, 25b: Leiterbahnabschnitt
- 27a, 27b: Kontaktstelle
- 29a, 29b: Sektor
- 31 a, 31 b, 31 c, 31 d: Kontaktstelle
- 33a, 33b, 33c, 33d: Kontaktstelle
- 35a, 35b: Leiterbahnabschnitt
- 37a, 37b: Kontaktstelle
- 39a, 39b: Sektor
- 51: Kontaktfläche
- 53: Kontaktfläche
- 71: Kontaktstelle
- 73: Kontaktstelle
- 75: Leuchtdiode
- 80: optisches Bauelement
- 82a, 82b: Führungszapfen
- 84: Positionsloch
- 85: optisches Bauelement
- 87a, 87b: Führungszapfen
- 91: Schlitz
- 93: Schlitz
- 100: Leuchte
- 102: Leuchtengehäuse
- 104: Leiterplatte
- 106: Leuchtdiodeneinheit
- 110a, 110b: Gruppe von Leuchtdiodeneinheiten
- 112a, 112b: Gruppe von Leuchtdiodeneinheiten
- 114a, 114b: Gruppe von Leuchtdiodeneinheiten
- E: Mittenebene der Leuchte
- L: Längsachse einer Leuchtdiodeneinheit

## Patentansprüche

1. Trägerelement zur Befestigung und elektrischen Verbindung einer oder mehrerer Leuchtdiodeneinheiten (20; 75), insbesondere Leiterplatte, mit einer oder mehreren Montagestellen für jeweils eine Leuchtdiodeneinheit, wobei jede Montagestelle eine oder mehrere Kontaktstellen zur elektrischen Verbindung mit der Leuchtdiodeneinheit (20, 75) aufweist, die in elektrischer Verbindung mit Leiterelementen des Trägerelements stehen,
wobei eine Leuchtdiodeneinheit an einer Montagestelle derart verdrehsicher befestigbar ist, daß ein elektrischer Kontakt zwischen einem oder mehreren Kontaktelementen der Leuchtdiodeneinheit mit einer oder mehreren Kontaktstellen (11a, 11b, 13a, 13b) des Trägerelements hergestellt wird,
**dadurch gekennzeichnet, daß** die Leuchtdiodeneinheit an einer Montagestelle in mehreren gegeneinander verdrehten Stellungen derart befestigbar ist, daß eine oder mehrere ihrer Kontaktelemente jeweils mit einer oder mehreren Kontaktstellen (11a, 11b, 13a, 13b) der Montagestelle in elektrischer Verbindung stehen.

2. Trägerelement nach Anspruch 1, **dadurch gekennzeichnet, daß** die Montagestelle mehrere Gruppen von Kontaktstellen (11a, 13a, 11b, 13b) aufweist, wobei die geometrische Anordnung der Kontaktstellen innerhalb einer Gruppe (11a, 13a; 11b, 13b) jeweils der geometrischen Anordnung der mit ihnen zu verbindenden Kontaktelemente der Leuchtdiodeneinheit (20) entspricht, wobei sich die Position der Kontaktstellen einer Gruppe (11b, 13b) durch eine Rotation aus der Position der Kontaktstellen einer anderen Gruppe (11a, 13a) ergibt.

3. Trägerelement nach Anspruch 2, **dadurch gekennzeichnet, daß** mehrere einander entsprechende Kontaktstellen (11a, 11b; 13a, 13b) in verschiedenen Gruppen auf einem Kreisbogen liegen und elektrisch leitend miteinander verbunden sind.

4. Trägerelement nach Anspruch 2 oder 3, **dadurch gekennzeichnet, daß** an der Montagestelle mehrere Gruppen von Kontaktstellen (11a, 11b; 13a, 13b) vorgesehen sind, wobei die Kontaktstellen innerhalb einer Gruppe elektrisch leitend miteinander verbunden sind, wobei die Abfolge der Winkelabstände der Kontaktstellen, bezogen auf eine Rotation um eine Achse (A) senkrecht zu der Oberfläche, an welcher die Leuchtdiodeneinheit anbringbar ist, in jeder Gruppe gleich ist.

5. Trägerelement nach einem der Ansprüche 1 bis 4, **gekennzeichnet durch** eine oder mehrere Gruppen von diskreten Kontaktstellen (11a, 11b; 13a, 13b), wobei die Kontaktstellen in einer Gruppe jeweils auf einem Kreisbogen liegen und wobei ein Kontaktelement der Leuchtdiodeneinheit wahlweise mit einer der Kontaktstellen einer Gruppe kontaktiert werden kann.

6. Trägerelement, insbesondere nach einem der Ansprüche 1 bis 5, zur Befestigung und elektrischen Verbindung einer oder mehrerer Leuchtdiodeneinheiten, insbesondere Leiterplatte, mit einer oder mehreren Montagestellen für jeweils eine Leuchtdiodeneinheit (20), wobei jede Montagestelle jeweils eine oder mehrere Kontaktstellen (11a, 11b, 13a, 13b) aufweist, die in elektrischer Verbindung mit Leiterelementen des Trägerelements stehen, wobei eine Leuchtdiodeneinheit (20) an einer Befestigungsstelle derart verdrehsicher befestigbar ist, daß ein oder mehrere Kontaktelemente der Leuchtdiodeneinheit mit einer oder mehreren Kontaktstellen des Trägerelements in elektrischer Verbindung stehen, **dadurch gekennzeichnet, daß** eine Montagestelle eine Einrichtung (84) zum Befestigen eines optischen Elements (80; 85) zum Zusammenwirken mit einem an der Montagestelle angebrachten Leuchtdiodeneinheit (20) aufweist, wobei die Einrichtung zum Befestigen des optischen Elements (84) das Fixieren des optischen Elements in mehreren Positionen gestattet, von denen jede sich durch Drehen des optischen Elements um eine Achse aus einer anderen dieser Positionen ergibt.

7. Trägerelement nach Anspruch 6, **gekennzeichnet durch** mehrere auf einem Kreisbogen liegende Befestigungselemente (84), mit denen eine bestimmte Befestigungsstelle des optischen Elements (80; 85) verbunden werden kann.

8. Trägerelement nach einem der Ansprüche 6 oder 7, **gekennzeichnet durch** ein kreisbogenförmiges Befestigungselement (91, 93) zum Festlegen der Position des optischen Elements, an oder in dem eine Befestigungsstelle des optischen Elements in mehreren Positionen angebracht werden kann.

9. Trägerelement nach einem der Ansprüche 1 bis 8**, dadurch gekennzeichnet, daß** an einer oder mehreren Montagestellen eine Leuchtdiodeneinheit (20; 75) angebracht ist.

10. Trägerelement nach Anspruch 9, **dadurch gekennzeichnet, daß** die Kontaktstelle bzw. Kontaktstellen der Montagestelle (11a, 11b, 13a, 13b) sich auf derjenigen Seite des Trägerelements befinden, an welcher die Leuchtdiodeneinheit montiert ist, wobei ein oder mehrere Kontaktelemente der Leuchtdiodeneinheit jeweils auf eine Kontaktstelle des Trägerelements aufgesetzt sind.

11. Trägerelement nach einem der Ansprüche 9 oder 10, **dadurch gekennzeichnet, daß** die Kontaktelemente der Leuchtdiodeneinheit durch ein Reflow-Lötverfahren an den Kontaktstellen (11a, 11b, 13a, 13b) des Trägerelements befestigt sind.

12. Trägerelement nach einem der Ansprüche 1 bis 12, **dadurch gekennzeichnet, daß** an einer Montagestelle ein einer Leuchtdiodeneinheit zugeordnetes optisches Element (80; 85) angebracht ist, wobei das optische Element (80; 85) insbesondere durch eine Rast- oder Steckverbindung (82a, 82b, 84; 87a, 87b, 91, 93) mit dem Trägerelement verbunden ist, und/oder das optische Element (80; 85) durch Kleben oder Löten an dem Trägerelement fixiert ist.

13. Leuchte, insbesondere Außenleuchte, welche eine oder mehrere Lichtquellen in Form von Leuchtdioden aufweist, **gekennzeichnet durch** ein Trägerelement nach einem der Ansprüche 1 bis 12.

14. Verfahren zum Bestücken einer Leiterplatte nach einem der Ansprüche 1 bis 12 mit einer oder mehreren Leuchtdiodeneinheiten, wobei die Kontaktstellen der Leiterplatte auf der Seite der Leiterplatte vorgesehen sind, auf der die Leuchtdiodeneinheit angebracht wird, **dadurch gekennzeichnet, daß** ein haftvermittelndes Lötmittel auf die Kontaktstellen der Montagestelle aufgebracht wird, die Leuchtdiodeneinheit auf die Leiterplatte in einer gewünschten Orientierung so aufgesetzt wird, daß die zu verbindenden Kontaktelemente der Leuchtdiodeneinheit über den zugehörigen Kontaktstellen der Montagestelle der Leiterplatte liegen, und daß anschließend ein Lötvorgang durchgeführt wird, durch welchen die Kontaktstellen mit den Kontaktelementen der Leuchtdiodeneinheit verbunden werden.

15. Verfahren nach Anspruch 14, **dadurch gekennzeichnet, daß** das Trägerelement an der Montagestelle eine Befestigungseinrichtung mit einer oder mehreren Befestigungsstellen für ein optisches Element aufweist, die eine Befestigung des optischen Elements in verschiedenen Orientierungen gestatten, daß vor dem Lötvorgang die Befestigungsstellen für das optische Element mit einem haftvermittelnden Lötmittel versehen werden, das optische Element in einer gewünschten Orientierung auf die entsprechende Befestigungsstelle oder Befestigungsstellen aufgesetzt wird und in einem Lötvorgang das optische Element und die zugehörige Leuchtdiodeneinheit jeweils mit dem Trägerelement verbunden werden.

## Claims

1. Support element for fastening and electrical connection of one or more LED units (20; 75), in particular a circuit board, with one or more installation points for one LED unit each, each installation point having one or more contact points for electrical connection with the LED unit (20, 75), which are electrically connected to conductor elements of the support element,
whereby one LED unit can be non-rotationally attached at an installation point in such a way that an electrical contact between one or more contact elements of the LED unit is established with one or more contact points (11a, 11b, 13a, 13b) of the support element, **characterised in that** the LED unit can be fixed at an installation point in several positions which are rotated relative to each other in such a way that one or more of its contact elements is or are electrically connected to one or more contact points (11a, 11b, 13a, 13b) of the installation point.

2. Support element according to claim 1, **characterised in that** the installation point has several groups of contact points (11a, 13a, 11b, 13b), the geometric arrangement of the contact points within one group (11a, 13a; 11b, 13b) corresponding to the geometric arrangement of the contact elements of the LED unit (20) to be connected with them, while the position of the contact points of a group (11b, 13b) results from a rotation out of position of the contact points of another group (11a, 13a).

3. Support element according to claim 2, **characterised in that** several matching contact points (11a, 11b; 13a, 13b) lie in various groups on an arc of a circle and are connected to each other in an electrically-conductive manner.

4. Support element according to claim 2 or 3, **characterised in that** several groups of contact points (11a, 11b; 13a, 13b) are provided at the installation point, the contact points within a group being connected to each other in an electrically-conductive manner, the sequence of angular distances of the contact points, in relation to a rotation about an axis (A) perpendicular to the surface on which the LED unit can be attached, being the same in each group.

5. Support element according to one of claims 1 to 4, **characterised by** one or more groups of discrete contact points (11a, 11b; 13a, 13b), wherein the contact points of each group lie on an arc of a circle and wherein a contact element of the LED unit can optionally be contacted with one of the contact points of a group.

6. Support element, in particular according to one of claims 1 to 5, for fastening and electrical connection of one or more LED units, in particular a circuit board, with one or more installation points for one LED unit (20) each, wherein each installation point has one or more contact points (11a, 11b, 13a, 13b) which are electrically connected to conductor elements of the support element, wherein one LED unit (20) can be non-rotatably attached at a fastening point in such a way that one or more contact elements of the LED unit are electrically connected to one or more contact points of the support element, **characterised in that** an installation point has a device (84) for fastening an optical element (80; 85) to interact with an LED unit (20) attached at the installation point, while the device for fastening the optical element (84) allows the optical element to be fixed in several positions, each of which results from rotating the optical element about an axis from another of these positions.

7. Support element according to claim 6, **characterised by** several fastening elements (84) lying on an arc of a circle, with which a defined fastening point of the optical element (80; 85) can be connected.

8. Support element according to one of claims 6 or 7, **characterised by** a fastening element (91, 93) in the form of an arc of a circle for fixing the position of the optical element, on or in which a fastening point for the optical element can be placed in several positions.

9. Support element according to one of claims 1 to 8, **characterised in that** an LED unit (20; 75) is attached at one or more installation points.

10. Support element according to claim 9, **characterised in that** the contact point or contact points of the installation point (11a, 11b, 13a, 13b) is or are located on that side of the support element at which the LED unit is mounted, with one or more contact elements of the LED unit being placed on a contact point of the support element.

11. Support element according to one of claims 9 or 10, **characterised in that** the contact elements of the LED unit are fastened by means of a reflow soldering process onto the contact points (11a, 11b, 13a, 13b) of the support element.

12. Support element according to one of claims 1 to 12, **characterised in that** an optical element (80; 85) assigned to an LED unit is attached at an installation point, the optical element (80; 85) in particular being connected to the support element by means of a snap or plug connection (82a, 82b, 84; 87a, 87b, 91, 93), and/or the optical element (80; 85) is fixed onto the support element by means of gluing or soldering.

13. Lighting, in particular exterior lighting, having one or more light sources in the form of LEDs, **characterised by** a support element according to one of claims 1 to 12.

14. Method for fitting out a circuit board according to one of claims 1 to 12 with one or more LED units, the contact points of the circuit board being provided on the side of the circuit board on which the LED unit is attached, **characterised in that** a bonding solder is applied to the contact points of the installation point, the LED unit is placed on the circuit board in a desired orientation in such a way that the contact elements of the LED unit to be connected lie over the associated contact points of the installation point of the circuit board, and that subsequently a soldering process is conducted by which the contact points are connected with the contact elements of the LED unit.

15. Method according to claim 14, **characterised in that** the support element has a fastening device at the installation point with one or more fastening points for an optical element, which allow the optical element to be fixed in various orientations, that the fastening points for the optical element are provided with a bonding solder before the soldering procedure, the optical element is placed in a desired orientation on the corresponding fastening point or fastening points and the optical element and the associated LED unit are each connected to the support element in a soldering process.

## Revendications

1. Élément de support pour la fixation et la liaison électrique d'une ou de plusieurs unités de diodes électroluminescentes (20 ; 75), en particulier une plaquette de circuits imprimés, comportant un ou plusieurs emplacements de montage pour respectivement une unité de diodes électroluminescentes, chaque emplacement de montage comportant un ou plusieurs points de contact pour la liaison électrique avec une unité de diodes électroluminescentes (20, 75), qui sont en liaison électrique avec des éléments conducteurs de l'élément de support,
sachant qu'une unité de diodes électroluminescentes est fixée immobile en rotation à un emplacement de montage, de telle sorte qu'un contact électrique est établi entre un ou plusieurs éléments de contact de l'unité de diodes électroluminescentes et un ou plusieurs points de contact (11a, 11b, 13a, 13b) de l'élément de support,
**caractérisé en ce que** l'unité de diodes électroluminescentes peut être fixée à un emplacement de montage dans plusieurs positions décalées les unes par rapport aux autres, de telle sorte qu'un ou plusieurs de ses éléments de contact sont en liaison électrique respectivement avec un ou plusieurs points de contact (11a, 11b, 13a, 13b) de l'emplacement de montage.

2. Élément de support selon la revendication 1, **caractérisé en ce que** l'emplacement de montage comporte plusieurs groupes de points de contact (11a, 13a, 11b, 13b), l'agencement géométrique des points de contact à l'intérieur d'un groupe (11a, 13a ; 11b, 13b) correspondant dans chaque cas à l'agencement géométrique des éléments de contact de l'unité de diodes électroluminescentes (20), qui sont à relier à ceux-ci, sachant que la position des points de contact d'un groupe (11b, 13b) résulte de la position des points de contact d'un autre groupe (11a, 13a) sous l'effet d'une rotation.

3. Élément de support selon la revendication 2, **caractérisé en ce que** plusieurs points de contact (11a, 11b ; 13a, 13b) correspondant entre eux dans différents groupes se situent sur un arc de cercle et sont reliés entre eux par une liaison électroconductrice.

4. Élément de support selon la revendication 2 ou 3, **caractérisé en ce que** plusieurs groupes de points de contact (11a, 11b ; 13a, 13b) sont prévus à un emplacement de montage, les points de contact à l'intérieur d'un groupe étant reliés entre eux par une liaison électroconductrice, sachant que la succession des distances angulaires entre les points de contact, par rapport à une rotation autour d'un axe (A) perpendiculaire à la surface sur laquelle l'unité de diodes électroluminescentes est destinée à être montée, est identique dans chaque groupe.

5. Élément de support selon l'une quelconque des revendications 1 à 4, **caractérisé par** un ou plusieurs groupes de points de contact (11a, 11b ; 13a, 13b) discrets, les points de contact dans un groupe étant situés respectivement sur un arc de cercle, et un élément de contact de l'unité de diodes électroluminescentes pouvant être mis en contact au choix avec l'un des points de contact d'un groupe.

6. Élément de support, en particulier selon l'une quelconque des revendications 1 à 5, destiné à la fixation et à la liaison électrique d'une ou de plusieurs unités de diodes électroluminescentes, en particulier une plaquette de circuits imprimés, comportant un ou plusieurs emplacements de montage pour respectivement une unité de diodes électroluminescentes (20), chaque emplacement de montage comportant respectivement un ou plusieurs points de contact (11a, 11b, 13a, 13b), qui sont en liaison électrique avec des éléments conducteurs de l'élément de support, sachant qu'une unité de diodes électroluminescentes (20) est fixée immobile en rotation en un point de fixation, de telle sorte qu'un ou plusieurs éléments de contact de l'unité de diodes électroluminescentes sont en liaison électrique avec un ou plusieurs points de contact de l'élément de support, **caractérisé en ce qu'**un emplacement de montage comporte un dispositif (84) pour la fixation d'un élément optique (80 ; 85) destiné à coopérer avec une unité de diodes électroluminescentes (20) montée à l'emplacement de montage, ledit dispositif pour la fixation de l'élément optique (84) permettant la fixation de l'élément optique dans plusieurs positions, dont chacune résulte d'une autre de ces positions sous l'effet de la rotation de l'élément optique autour d'un axe.

7. Élément de support selon la revendication 6, **caractérisé par** plusieurs éléments de fixation (84), situés sur un arc de cercle, avec lesquels un point de fixation déterminé de l'élément optique (80 ; 85) peut être relié.

8. Élément de support selon la revendication 6 ou 7, **caractérisé par** un élément de fixation (91, 93) en forme d'arc de cercle, destiné à définir la position de l'élément optique, sur ou dans lequel un point de fixation de l'élément optique peut être amené dans plusieurs positions.

9. Élément de support selon l'une quelconque des revendications 1 à 8, **caractérisé en ce qu'**une unité de diodes électroluminescentes (20 ; 75) est montée sur un ou plusieurs emplacements de montage.

10. Élément de support selon la revendication 9, **caractérisé en ce que** le point de contact ou les points de contact (11a, 11b, 13a, 13b) de l'emplacement de montage sont situés sur le côté de l'élément de support, sur lequel est montée l'unité de diodes électroluminescentes, un ou plusieurs éléments de contact de l'unité de diodes électroluminescentes étant posés respectivement sur un point de contact de l'élément de support.

11. Élément de support selon la revendication 9 ou 10, **caractérisé en ce que** les éléments de contact de l'unité de diodes électroluminescentes sont fixés sur les points de contact (11a, 11b, 13a, 13b) par un procédé de brasage par fusion.

12. Élément de support selon l'une quelconque des revendications 1 à 12, **caractérisé en ce qu'**un élément optique (80 ; 85), associé à une unité de diodes électroluminescentes, est monté à un emplacement de montage, ledit élément optique (80 ; 85) étant relié à l'élément de support en particulier par un assemblage par encliquetage ou un assemblage par enfichage (82a, 82b, 84 ; 87a, 87b, 91, 93), et/ou l'élément optique (80 ; 85) est fixé sur l'élément de support par collage ou brasage.

13. Luminaire, en particulier luminaire d'extérieur, qui comporte une ou plusieurs sources lumineuses en forme de diodes électroluminescentes, **caractérisé par** un élément de support selon l'une quelconque des revendications 1 à 12.

14. Procédé pour équiper une plaquette de circuits imprimés selon l'une quelconque des revendications 1 à 12 avec une ou plusieurs unités de diodes électroluminescentes, les points de contact de la plaquette de circuits imprimés étant prévus sur la face de la plaquette de circuits imprimés sur laquelle est montée l'unité de diodes électroluminescentes, **caractérisé en ce qu'**une brasure à pouvoir adhésif, est déposée sur les points de contact de l'emplacement de montage, l'unité de diodes électroluminescentes est posée sur la plaquette de circuits imprimés dans une orientation souhaitée, de telle sorte que les éléments de contact à relier de l'unité de diodes électroluminescentes sont situés au-dessus des points de contact associés de l'emplacement de montage de la plaquette de circuits imprimés, et **en ce qu'**un processus de brasage est mis en oeuvre ensuite, par lequel les points de contact sont reliés aux éléments de contact de l'unité de diodes électroluminescentes.

15. Procédé selon la revendication 14, **caractérisé en ce que** l'élément de support, au niveau de l'emplacement de montage, comporte un dispositif de fixation avec un ou plusieurs points de fixation pour un élément optique, lesquels permettent une fixation de l'élément optique dans différentes orientations, **en ce que**, avant le processus de brasage, les points de fixation pour l'élément optique sont revêtus d'une brasure à pouvoir adhésif, l'élément optique est posé dans une orientation souhaitée sur le point de fixation ou les points de fixation correspondant(s) et, dans un processus de brasage, l'élément optique et l'unité de diodes électroluminescentes associée sont reliés chacun à l'élément de support.
